# EUROPEAN PATENT SPECIFICATION

(11) **EP 4 333 057 B1**
(45) Date of publication and mention of the grant of the patent: **11.02.2026**
(21) Application number: 23194108.9
(22) Date of filing: 29.08.2023
(51) Int. Cl.: H10H 29/49, H10H 29/80

(54) **DISPLAY DEVICE AND METHOD OF FABRICATING THE SAME**
ANZEIGEVORRICHTUNG UND VERFAHREN ZU IHRER HERSTELLUNG
DISPOSITIF D'AFFICHAGE ET SON PROCÉDÉ DE FABRICATION

(30) Priority: 02.09.2022 KR 20220111712
(43) Date of publication of application: 06.03.2024
(73) Proprietor: Samsung Display Co., Ltd., Yongin-si, Gyeonggi-do 17113 (KR)
(72) Inventor: LEE, Hyun Wook, 17113 Yongin-si (KR); BAE, Sung Geun, 17113 Yongin-si (KR); PARK, Jang Soon, 17113 Yongin-si (KR); SONG, Myeong Hun, 17113 Yongin-si (KR); LEE, Tae Hee, 17113 Yongin-si (KR)
(74) Representative: Walaski, Jan Filip

(56) References cited:
- US-A1- 2021 143 137
- US-A1- 2022 011 487
- US-A1- 2022 130 922

## Description

### BACKGROUND

### 1. Field

The present invention relates to a display device and a method of fabricating the display device.

### 2. Description of Related Art

Recently, as interest in information display increases, research and development on display devices have been continuously conducted. US 2022/011487 A1 and US 2022/130922 A1 each disclose display devices with insulating layers disposed above and below a light emitting element.

### SUMMARY

One or more embodiments of the present invention are directed to a display device having improved reliability.

Furthermore, one or more embodiments of the present invention are directed to a method of fabricating the display device.

According to the invention, there is provided a display device according to claim 1, and a method of fabricating a display device according to claim 12. Preferred features are set out in the dependent claims.

In accordance with the present invention, a dummy pattern is located in a space (e.g., a void or a gap) enclosed by a light emitting element and an insulating layer located under the light emitting element, so that a first electrode and a second electrode in the space may be prevented from short-circuiting with each other, whereby the reliability may be enhanced.

The effects, aspects, and features of the present invention are not limited by the foregoing, and other various effects, aspects, and features are anticipated herein.

### BRIEF DESCRIPTION OF THE DRAWINGS

FIG. 1 is a schematic perspective view illustrating a light emitting element.
FIG. 2 is a schematic cross-sectional view illustrating the light emitting element of FIG. 1.
FIG. 3 is a schematic plan view illustrating a display device.
FIGS. 4 and 5 are schematic circuit diagrams illustrating an electrical connection relationship of components included in each of pixels illustrated in FIG. 3.
FIG. 6 is a schematic plan view illustrating a display element layer of a pixel.
FIG. 7 is a schematic cross-sectional view taken along the line I-I' of FIG. 6.
FIGS. 8 to 12 are schematic cross-sectional views taken along the line II-II' of FIG. 6.
FIGS. 13A to 13D are schematic enlarged views of a portion EA of FIG. 8.
FIG. 14 is a schematic cross-sectional view taken along the line III-III' of FIG. 6.
FIG. 15 is a schematic cross-sectional view taken along the line IV-IV' of FIG. 6.
FIG. 16 is a schematic cross-sectional view taken along the line V-V' of FIG. 6.
FIGS. 17 and 18 illustrate a pixel, and are schematic cross-sectional views corresponding to the line II-II' of FIG. 6.
FIGS. 19 to 27 are views for describing a method of fabricating a display device in, and are schematic cross-sectional views corresponding to the line II-II' and the line IV - IV' of FIG. 6.

### DETAILED DESCRIPTION

As the present invention allows for various changes and numerous embodiments, particular embodiments will be illustrated in the drawings and described in detail in the written description. However, this is not intended to limit the present invention to particular modes of practice, and it is to be appreciated that all changes, equivalents, and substitutes that do not depart from the technical scope of the invention as defined by the claims are encompassed in the present disclosure.

Throughout the present invention, like reference numerals refer to like parts throughout the various figures and embodiments of the present invention. The sizes of elements in the accompanying drawings may be exaggerated for clarity of illustration. It will be understood that, although the terms "first", "second", etc. may be used herein to describe various elements, these elements should not be limited by these terms. These terms are only used to distinguish one element from another element. For instance, a first element discussed below could be termed a second element without departing from the teachings of the present invention. Similarly, the second element could also be termed the first element.

It will be further understood that the terms "comprise", "include", "have", etc. when used in this specification, specify the presence of stated features, integers, steps, operations, elements, components, and/or combinations of them but do not preclude the presence or addition of one or more other features, integers, steps, operations, elements, components, and/or combinations thereof. Furthermore, in case that a first part such as a layer, a film, a region, or a plate is disposed on a second part, the first part may be not only directly on the second part but a third part may intervene between them. In addition, in case that it is expressed that a first part such as a layer, a film, a region, or a plate is formed on a second part, the surface of the second part on which the first part is formed is not limited to an upper surface of the second part but may include other surfaces such as a side surface or a lower surface of the second part. To the contrary, in case that a first part such as a layer, a film, a region, or a plate is under a second part, the first part may be not only directly under the second part but a third part may intervene between them.

It will be understood that when an element (e.g., a first element) is referred to as being (operatively or communicatively) "coupled with/to," or "connected with/to" another element (e.g., a second element), the first element may be coupled or connected with/to the second element directly or via another element (e.g., a third element). In contrast, it will be understood that when an element (e.g., a first element) is referred to as being "directly coupled with/to" or "directly connected with/to" another element (e.g., a second element), no other element (e.g., a third element) intervenes between the element and the other element.

Embodiments and required details of the present disclosure are described with reference to the accompanying drawings in order to describe the present disclosure in detail so that those having ordinary knowledge in the technical field to which the present disclosure pertains may easily practice the present disclosure. Furthermore, a singular form may include a plural form as long as it is not specifically mentioned in a sentence.

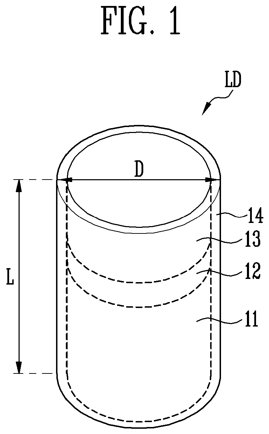

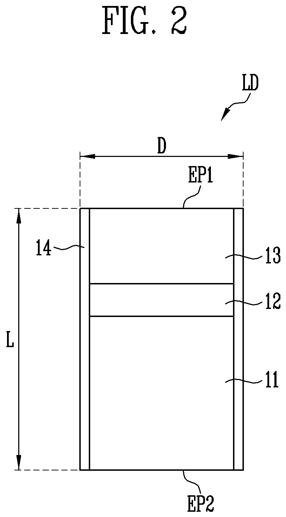

FIG. 1 is a schematic perspective view illustrating a light emitting element LD. FIG. 2 is a schematic cross-sectional view illustrating the light emitting element LD of FIG. 1.

Referring to FIGS. 1 and 2, the light emitting element LD may include a first semiconductor layer 11, a second semiconductor layer 13, and an active layer 12 interposed between the first and second semiconductor layers 11 and 13. For example, the light emitting element LD may be implemented as an emission stack (or referred to as "stack pattern") formed by successively stacking the first semiconductor layer 11, the active layer 12, and the second semiconductor layer 13. The type and/or shape of the light emitting element LD is not limited to that illustrated in FIG. 1.

The light emitting element LD may be formed in a shape extending in one direction. If the direction in which the light emitting element LD extends is defined as a longitudinal direction, the light emitting element LD may have a first end EP1 and a second end EP2 that are opposite to each other with respect to the longitudinal direction. One semiconductor layer of the first semiconductor layer 11 and the second semiconductor layer 13 may be disposed on the first end EP1 of the light emitting element LD, and the other semiconductor layer of the first semiconductor layer 11 and the second semiconductor layer 13 may be disposed on the second end EP2 of the light emitting element LD. For example, the second semiconductor layer 13 may be disposed on the first end EP1 of the light emitting element LD, and the first semiconductor layer 11 may be disposed on the second end EP2 of the light emitting element LD.

The light emitting element LD may be provided in various shapes. For example, as illustrated in FIG. 1, the light emitting element LD may have a rod-like shape, a bar-like shape, or a pillar-like shape that is long with respect to the longitudinal direction (i.e., to have an aspect ratio greater than 1). Alternatively, the light emitting element LD may have a rod-like shape, a bar-like shape, or a pillar-like shape that is short with respect to the longitudinal direction (or has an aspect ratio less than 1). As a further alternative, the light emitting element LD may have a rod-like shape, a bar-like shape, or a pillar-like shape having an aspect ratio of 1.

The light emitting element LD may include a light emitting diode (LED) fabricated to have a subminiature size, e.g., with a diameter D and/or a length L corresponding to a range from the nano scale (or the nanometer scale) to the micro scale (or the micrometer scale).

In case that the light emitting element LD is long (i.e., to have an aspect ratio greater than 1) with respect to the longitudinal direction, the diameter D of the light emitting element LD may approximately range from 0.5 µm to 6 µm, and the length L thereof may approximately range from 1 µm to 10 µm. However, the diameter D and the length L of the light emitting element LD are not limited thereto. The size of the light emitting element LD may be changed to meet requirements (or design conditions) of a lighting device or a self-emissive display device to which the light emitting element LD is applied.

The first semiconductor layer 11 may include, for example, at least one n-type semiconductor layer. For instance, the first semiconductor layer 11 may include an n-type semiconductor layer that includes any one semiconductor material selected from among InAlGaN, GaN, AlGaN, InGaN, AlN, and InN and is doped with a first conductive dopant (or an n-type dopant) such as Si, Ge, or Sn. However, the constituent material of the first semiconductor layer 11 is not limited to thereto, and various other materials may be used to form the first conductive semiconductor layer 11.

The active layer 12 may be disposed on the first semiconductor layer 11 and have a single- or multi-quantum well structure. For example, in case that the active layer 12 has a multi-quantum well structure, the active layer 12 may be formed by periodically repeatedly stacking a barrier layer, a strain reinforcing layer, and a well layer that are provided as one unit. The strain reinforcing layer may have a lattice constant less than that of the barrier layer so that resistance to strain, e.g., compressive strain, to be applied to the well layer may be further reinforced. However, the structure of the active layer 12 is not limited to that of the foregoing.

The active layer 12 may emit light having a wavelength ranging from 400 nm to 900 nm, and have a double hetero structure. A clad layer doped with a conductive dopant may be formed over or under the active layer 12 with respect to the longitudinal direction of the light emitting element LD. For example, the clad layer may be formed of an AlGaN layer or an InAlGaN layer. Material such as AlGaN or InAlGaN may be used to form the active layer 12, and various other materials may be used to form the active layer 12. The active layer 12 may include a first surface that contacts the first semiconductor layer 11, and a second surface that contacts the second semiconductor layer 13.

If an electric field having a suitable voltage (e.g., a set or predetermined voltage) or more is applied between the opposite ends EP1 and EP2 of the light emitting element LD, the light emitting element LD may emit light by coupling of electron-hole pairs in the active layer 12. Because light emission of the light emitting element LD may be controlled based on the foregoing principle, the light emitting element LD may be used as a light source (e.g., a light emitting source) of various light emitting devices as well as a pixel of a display device.

The second semiconductor layer 13 may be disposed on the second surface of the active layer 12 and include a semiconductor layer of a type different from that of the first semiconductor layer 11. For example, the second semiconductor layer 13 may include at least one p-type semiconductor layer. For instance, the second semiconductor layer 13 may include a p-type semiconductor layer that includes any one semiconductor material selected from among InAlGaN, GaN, AlGaN, InGaN, AlN, and InN, and is doped with a second conductive dopant (or a p-type dopant) such as Mg, Zn, Ca, Sr, or Ba. However, the material for forming the second semiconductor layer 13 is not limited thereto, and various other materials may be used to form the second semiconductor layer 13.

The first semiconductor layer 11 and the second semiconductor layer 13 may have different thicknesses with respect to the longitudinal direction of the light emitting element LD. For example, the first semiconductor layer 11 may have a thickness greater than that of the second semiconductor layer 13 with respect to the longitudinal direction of the light emitting element LD. Hence, the active layer 12 of the light emitting element LD may be disposed at a position closer to the upper surface of the second semiconductor layer 13 than to the lower surface of the first semiconductor layer 11.

Although FIGS. 1 and 2 illustrate that the first semiconductor layer 11 and the second semiconductor layer 13 each is formed of a single layer, the present disclosure is not limited thereto. Depending on the material of the active layer 12, the first semiconductor layer 11 and the second semiconductor layer 13 each may further include one or more layers, for example, a clad layer and/or a tensile strain barrier reducing (TSBR) layer. The TSBR layer may be a strain relief layer that is disposed between semiconductor layers having different lattice structures and thus may function as a buffer layer to reduce a difference in lattice constant. Although the TSBR layer may be formed of a p-type semiconductor layer such as p-GaInP, p-AlInP, or p-AlGaInP, the present disclosure is not limited thereto.

The light emitting element LD may further include a contact electrode (hereinafter referred to as a "first contact electrode") disposed over the second semiconductor layer 13, as well as including the first semiconductor layer 11, the active layer 12, and the second semiconductor layer 13. Furthermore, the light emitting element LD may further include another contact electrode (hereinafter referred to as a "second contact electrode") disposed on one end of the first semiconductor layer 11.

Each of the first and second contact electrodes may be an ohmic contact electrode, but the present disclosure is not limited thereto. Each of the first and second contact electrodes may be a Schottky contact electrode. The first and second contact electrodes may include conductive material. For example, the first and second contact electrodes may include opaque metal such as chrome (Cr), titanium (Ti), aluminum (Al), gold (Au), nickel (Ni), and oxides or alloys thereof, which are used alone or in combination, but the present disclosure is not limited thereto. The first and second contact electrodes may also include transparent conductive oxides such as indium tin oxide (ITO), indium zinc oxide (IZO), zinc oxide (ZnOₓ), indium gallium zinc oxide (IGZO), and indium tin zinc oxide (ITZO). Here, the zinc oxide (ZnOₓ) may be zinc oxide (ZnO) and/or zinc peroxide (ZnO₂).

Materials included in the first and second contact electrodes may be equal to or different from each other. The first and second contact electrodes may be substantially transparent or translucent. Therefore, light generated from the light emitting element LD may pass through each of the first and second contact electrodes and then may be emitted out of the light emitting element LD. In the case that light generated from the light emitting element LD is emitted out of the light emitting element LD through an area other than the first end EP1 and the second end EP2 of the light emitting element LD rather than passing through the first and second contact electrodes, the first and second contact electrodes may include an opaque metal.

The light emitting element LD may further include an insulating layer 14. However, the insulating layer 14 may be omitted, or may be provided to cover only some of the first semiconductor layer 11, the active layer 12, and the second semiconductor layer 13.

The insulating layer 14 may prevent the active layer 12 from short-circuiting due to making contact with conductive material except the first and second semiconductor layers 11 and 13. Furthermore, the insulating layer 14 may reduce or minimize a surface defect of the light emitting element LD, thus enhancing the lifetime and emission efficiency of the light emitting element LD. In case that a plurality of light emitting elements LD are disposed in close contact with each other, the insulating layer 14 may prevent an undesired short-circuit from occurring between the light emitting elements LD. The presence or non-presence of the insulating layer 14 is not limited, so long as the active layer 12 may be prevented from short-circuiting with external conductive material.

The insulating layer 14 may be provided to be around (e.g., to enclose) an overall outer surface (e.g., an outer peripheral or circumferential surface) of the emission stack including the first semiconductor layer 11, the active layer 12, and the second semiconductor layer 13.

Although in the foregoing the insulating layer 14 has been described as being around (e.g., enclosing) the entirety of the respective outer surfaces (e.g., an outer peripheral or circumferential surfaces) of the first semiconductor layer 11, the active layer 12, and the second semiconductor layer 13, the present disclosure is not limited thereto. In the case that the light emitting element LD includes the first contact electrode, the insulating layer 14 may be around (e.g., may enclose) the entirety of the respective outer surfaces (e.g., the respective outer peripheral or circumferential surfaces) of the first semiconductor layer 11, the active layer 12, the second semiconductor layer 13, and the first contact electrode. The insulating layer 14 may not enclose the entirety of the outer surface (e.g., an outer peripheral or circumferential surface) of the first semiconductor layer 11, or may be around (e.g., may enclose) only a portion of the outer surface (e.g., an outer peripheral or circumferential surface) of the first semiconductor layer 11 without being around (e.g., enclosing) the other portion of the outer surface (e.g., an outer peripheral or circumferential surface) of the first semiconductor layer 11. Furthermore, in the case that the first contact electrode is disposed on the first end EP1 of the light emitting element LD and the second contact electrode is disposed on the second end EP2 of the light emitting element LD, the insulating layer 14 may allow at least one area of each of the first and second contact electrodes to be exposed.

The insulating layer 14 may include transparent insulating material. For example, the insulating layer 14 may include one or more insulating materials selected from the group consisting of silicon oxide (SiOₓ), silicon nitride (SiNₓ), silicon oxynitride (SiOₓN_{y}), aluminum oxide (AlOₓ), titanium oxide (TiOₓ), hafnium oxide (HfOₓ), titanstrontium oxide (SrTiOₓ), cobalt oxide (CoₓO_{y}), magnesium oxide (MgO), zinc oxide (ZnOₓ), ruthenium Oxide (RuOₓ), nickel oxide (NiO), tungsten oxide (WOₓ), tantalum oxide (TaOₓ), gadolinium oxide (GdOₓ), zirconium oxide (ZrOₓ), gallium oxide (GaOₓ), vanadium oxide (VₓO_{y}), ZnO:Al, ZnO:B, InxOy:H, niobium oxide (NbₓO_{y}), magnesium fluoride (MgFₓ), aluminum fluoride (AlFₓ), an alucone polymer film, titanium nitride (TiN), tantalum nitride (TaN), aluminum nitride (AlNₓ), gallium nitride (GaN), tungsten nitride (WN), hafnium nitride (HfN), niobium nitride (NbN), gadolinium nitride (GdN), zirconium nitride (ZrN), and vanadium nitride (VN). However, the present disclosure is not limited thereto, and various materials having insulation may be used as the material of the insulating layer 14.

The insulating layer 14 may have a single-layer structure or a multi-layer structure including a double-layer structure. For example, in case that the insulating layer 14 is formed of a double layer structure including a first insulating layer and a second insulating layer that are successively stacked, the first insulating layer and the second insulating layer may be made of different materials (or substances) and may be formed through different processes. The first insulating layer and the second insulating layer may include the same material and be formed through successive processes.

The light emitting element LD may be implemented as a light emitting pattern having a core-shell structure.

The light emitting element LD may be employed as a light emitting source (or a light source) for various display devices. The light emitting element LD may be fabricated through a surface treatment process. For example, the light emitting element LD may be surface-treated so that, in case that a plurality of light emitting elements LD are mixed with a fluidic solution (or solvent) and then supplied to each pixel area (e.g., an emission area of each pixel or an emission area of each sub-pixel), the light emitting elements LD may be evenly distributed rather than unevenly aggregating in the solution.

An emission component (or a light emitting device or a light emitting unit) including the light emitting element LD described above may be used not only in a display device but also in various types of electronic devices each of which requires a light source.

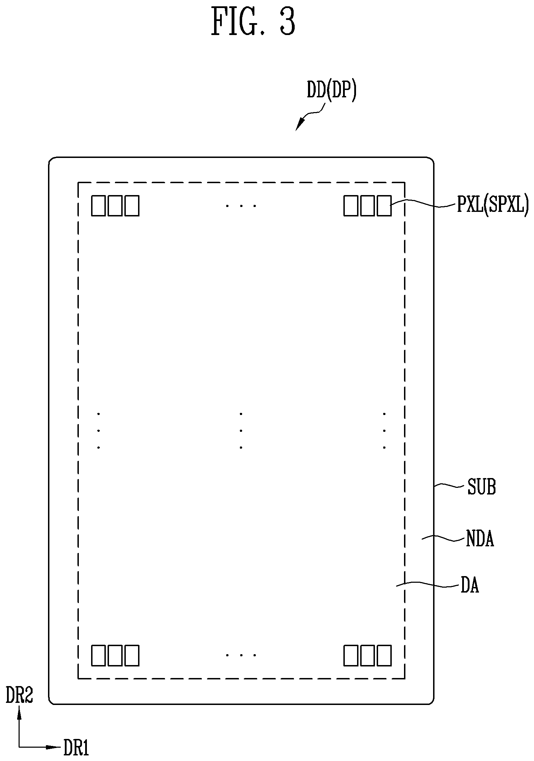

FIG. 3 is a schematic plan view illustrating the display device DD.

In FIG. 3, for the sake of explanation, there is schematically illustrated the structure of the display device DD, for example, a display panel DP provided in the display device DD, centered on a display area DA in which an image is displayed.

Referring to FIGS. 1 to 3, the display device DD may be classified into a passive matrix type display device and an active matrix type display device according to a method of driving the light emitting element LD. For example, in case that the display device DD is implemented as an active matrix type, each of the pixels PXL may include a driving transistor configured to control the amount of current to be supplied to the light emitting element LD, and a switching transistor configured to transmit data signals to the driving transistor.

The display panel DP (or the display device DD) may include a substrate SUB, and pixels PXL disposed on the substrate SUB. Each of the pixels PXL may include a plurality of sub-pixels SPXL. Each sub-pixel SPXL may include at least one light emitting element LD.

The substrate SUB may include a display area DA and a non-display area NDA around an edge or periphery of the display area DA.

The display area DA may be an area in which the pixels PXL for displaying an image are provided. The non-display area NDA may be an area in which a driver for driving each pixel PXL (or the sub-pixels SPXL) and a portion of a line component for connecting each pixel PXL to the driver are provided.

The non-display area NDA may be disposed adjacent to the display area DA. The non-display area NDA may be provided on at least one side of the display area DA. For example, the non-display area NDA may be around (e.g., may enclose) the perimeter (or edges) of the display area DA. A line component electrically connected to each of the pixels PXL, and a driver electrically connected to the line component and configured to drive the pixel PXL may be provided in the non-display area NDA.

The line component may electrically connect the driver with each pixel PXL. The line component may be a fanout line electrically connected with signal lines, e.g., a scan line, and a data line, which are electrically connected to each pixel PXL to provide signals to the pixel PXL. The line component may include a fanout line electrically connected to signal lines, e.g., a control line, and a sensing line, which are electrically connected to each pixel PXL to compensate in real time for variation in electrical characteristics of the pixel PXL. The line component may include a fanout line electrically connected with power lines that are electrically connected to the respective pixels PXL to provide voltages to the respective pixels PXL.

The substrate SUB may include transparent insulating material to allow light transmission. The substrate SUB may be a rigid substrate or a flexible substrate.

For example, the rigid substrate SUB may be one of a glass substrate, a quartz substrate, a glass ceramic substrate, and a crystalline glass substrate.

The flexible substrate SUB may be either a film substrate or a plastic substrate that includes polymer organic material. For example, the flexible substrate SUB may include at least one selected from among the following: polystyrene, polyvinyl alcohol, polymethyl methacrylate, polyethersulfone, polyacrylate, polyetherimide, polyethylene naphthalate, polyethylene terephthalate, polyphenylene sulfide, polyarylate, polyimide, polycarbonate, triacetate cellulose, and cellulose acetate propionate.

One area of the substrate SUB may be provided as the display area DA in which the pixels PXL are disposed, and the other area of the substrate SUB may be provided as the non-display area NDA. For example, the substrate SUB may include a display area DA including a plurality of pixel areas in which the respective pixels PXL are disposed, and a non-display area NDA disposed around the perimeter of the display area DA (or adjacent to the display area DA).

The pixels PXL may be provided in the display area DA of the substrate SUB. The pixels PXL may be arranged in the display area DA in a stripe arrangement manner or a PENTILE^{®} arrangement structure, or the like, but the present disclosure is not limited thereto and various embodiments known in the art may be applied. This PENTILE^{®} arrangement structure may be referred to as an RGBG matrix structure (e.g., a PENTILE^{®} matrix structure or an RGBG structure (e.g., a PENTILE^{®} structure)). PENTILE^{®} is a registered trademark of Samsung Display Co., Ltd., Republic of Korea.

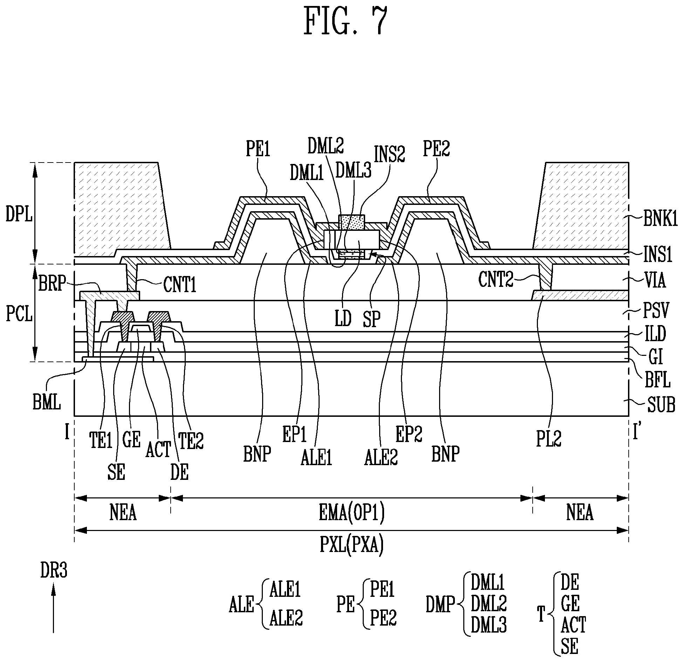

Each pixel PXL may include a pixel circuit layer (refer to "PCL" of FIG. 7) and a display element layer (refer to "DPL" of FIG. 7) that are disposed on the substrate SUB.

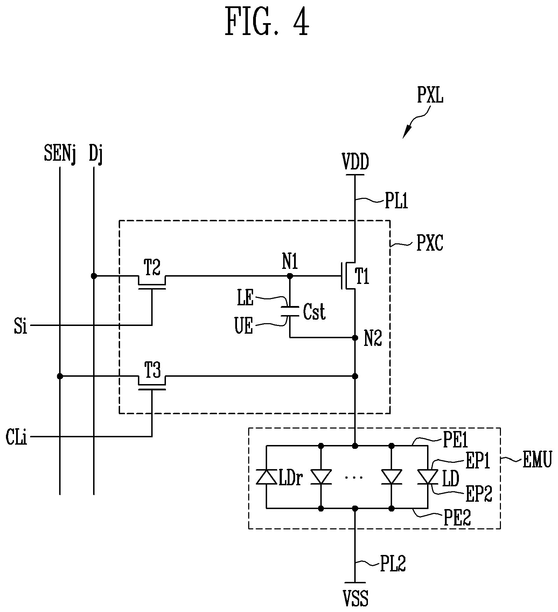

A pixel circuit (refer to "PXC" of FIG. 4) that is provided on the substrate SUB and includes a plurality of transistors and signal lines electrically connected to the transistors may be disposed in the pixel circuit layer PCL. For example, each transistor has a structure in which a semiconductor layer, a gate electrode, a first terminal, and a second terminal are successively stacked with insulating layers interposed therebetween. The semiconductor layer may include amorphous silicon, poly silicon, low temperature poly silicon, and an organic semiconductor, and/or an oxide semiconductor. Although the gate electrode, the first terminal (or the source electrode), and the second terminal (or the drain electrode) each may include one of aluminum (Al), copper (Cu), titanium (Ti), and molybdenum (Mo), the present disclosure is not limited thereto. In addition, the pixel circuit layer PCL may include at least one or more insulating layers.

The display element layer DPL may be disposed on the pixel circuit layer PCL. An emission component (refer to "EMU" of FIG. 4) including a light emitting element LD configured to emit light may be disposed in the display element layer DPL. A first alignment electrode (or a first alignment line) and a second alignment electrode (or a second alignment line) that are spaced from each other may be disposed in the emission component EMU. The light emitting element LD may be disposed between the first alignment electrode and the second alignment electrode. The configuration of each pixel PXL will be described in detail later herein.

Each pixel PXL may include at least one or more light emitting elements LD configured to be driven in response to a corresponding scan signal and a corresponding data signal. The light emitting element LD may have a small size ranging from the nano scale (or the nanometer scale) to the micro scale (the mircrometer scale) and may be electrically connected in parallel to light emitting elements LD disposed adjacent thereto, but the present disclosure is not limited thereto. The light emitting element LD may form a light source of each pixel PXL.

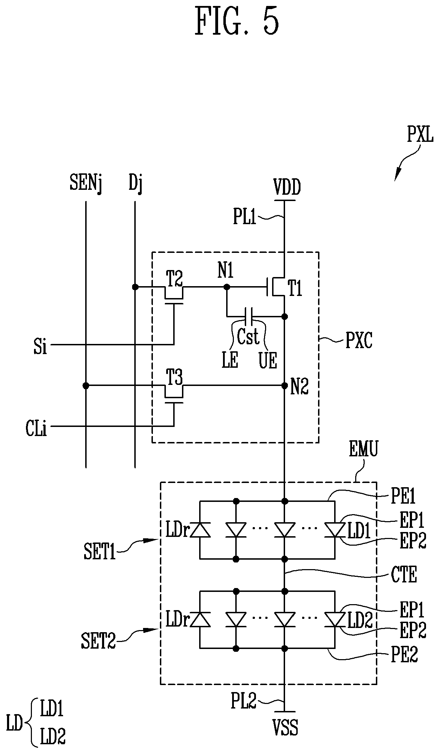

FIGS. 4 and 5 are schematic circuit diagrams illustrating an electrical connection relationship of components included in each of the pixels PXL illustrated in FIG. 3.

For example, FIGS. 4 and 5 illustrate examples of the electrical connection relationship of components included in the pixel PXL that may be employed in an active matrix type display device. Here, the connection relationship of the components of each pixel PXL is not limited thereto.

Referring to FIGS. 1 to 4, the pixel PXL may include an emission component EMU (or an emission unit) configured to generate light having a luminance corresponding to a data signal. Furthermore, the pixel PXL may optionally further include a pixel circuit PXC configured to drive the emission component EMU.

The emission component EMU may include a plurality of light emitting elements LD electrically connected in parallel between a first power line PL1 that is electrically connected to a first driving power supply VDD and configured to be supplied with a voltage of the first driving power supply VDD, and a second power line PL2 that is electrically connected to a second driving power supply VSS and configured to be supplied with a voltage of the second driving power supply VSS. For example, the emission component EMU may include a first electrode PE1 (or a first pixel electrode) electrically connected to the first driving power supply VDD via the pixel circuit PXC and the first power line PL1, a second electrode PE2 (or a second pixel electrode) electrically connected to the second driving power supply VSS by the second power line PL2, and a plurality of light emitting elements LD electrically connected in parallel to each other in the same direction between the first and second pixel electrodes PE1 and PE2. The first electrode PE1 may be an anode, and the second electrode PE2 may be a cathode.

The first driving power supply VDD may be set to a high-potential power supply, and the second driving power supply VSS may be set to a low-potential power supply. Here, a difference in potential between the first and second driving power supplies VDD and VSS may be set to a value equal to or greater than a threshold voltage of the light emitting elements LD during an emission period of the pixel PXL.

Each of the light emitting elements LD may include a first end EP1 (e.g., a p-type end) electrically connected to the first driving power supply VDD via at least one electrode (e.g., the first electrode PE1), the pixel circuit PXC, the first power line PL1, and/or the like, and a second end EP2 (e.g., an n-type end) electrically connected to the second driving power supply VSS via at least one additional electrode (e.g., the second electrode PE2), the second power line PL2, and the like. In other words, the light emitting elements LD may be electrically connected in the forward direction between the first driving power supply VDD and the second driving power supply VSS. The light emitting elements LD electrically connected in the forward direction may form valid light sources of the emission component EMU.

The light emitting elements LD of the emission component EMU may emit light having a luminance corresponding to driving current supplied thereto through the pixel circuit PXC. For example, during each frame period, driving current that corresponds to a gray scale value of a corresponding frame data of the pixel circuit PXC may be supplied to the light emission component EMU. The driving current supplied to the emission component EMU may be divided into parts that flow into the respective light emitting elements LD. Hence, each of the light emitting elements LD may emit light having a luminance corresponding to current applied thereto, so that the emission component EMU may emit light having a luminance corresponding to the driving current.

Although there has been described the implementation in which the opposite ends EP1 and EP2 of the light emitting elements LD are electrically connected in the same direction between the first and second driving power supplies VDD and VSS, the present disclosure is not limited thereto. The emission component EMU may further include at least one invalid light source, e.g., a reverse light emitting element LDr, as well as including the light emitting elements LD that form the respective valid light sources. The reverse light emitting element LDr, along with the light emitting elements LD that form the valid light sources, may be electrically connected in parallel to each other between the first and second electrodes PE1 and PE1. Here, the reverse light emitting element LDr may be electrically connected between the first and second electrodes PE1 and PE2 in a direction opposite to that of the light emitting elements LD. Even if a driving voltage (e.g., a forward driving voltage) is applied between the first and second electrodes PE1 and PE2, the reverse light emitting element LDr remains disabled. Hence, current substantially does not flow through the reverse light emitting element LDr.

The pixel circuit PXC may be electrically connected to a scan line Si and a data line Dj of the pixel PXL. The pixel circuit PXC may be electrically connected to a control line CLi and a sensing line SENj of the pixel PXL. For example, in case that the pixel PXL is disposed on an i-th row and a j-th column of the display area DA, the pixel circuit PXC of the pixel PXL may be electrically connected to an i-th scan line Si, a j-th data line Dj, an i-th control line CLi, and a j-th sensing line SENj of the display area DA.

The pixel circuit PXC may include first to third transistors T1 to T3, and a storage capacitor Cst.

The first transistor T1 may be a driving transistor configured to control driving current to be applied to the emission component EMU, and may be electrically connected between the first driving power supply VDD and the emission component EMU. In detail, a first terminal of the first transistor T1 may be electrically connected to the first driving power supply VDD by the first power line PL1. A second terminal of the first transistor T1 may be electrically connected to a second node N2. A gate electrode of the first transistor T1 may be electrically connected to a first node N1. The first transistor T1 may control, in response to a voltage applied to the first node N1, the amount of driving current to be applied from the first driving power supply VDD to the emission component EMU through the second node N2The first terminal of the first transistor T1 may be a drain electrode, and the second terminal of the first transistor T1 may be a source electrode, however the present disclosure is not limited thereto. The first terminal may be a source electrode, and the second terminal may be a drain electrode.

The second transistor T2 may be a switching transistor that selects a pixel PXL in response to a scan signal and activates the pixel PXL, and may be electrically connected between the data line Dj and the first node N1. A first terminal of the second transistor T2 may be electrically connected to the data line Dj. A second terminal of the second transistor T2 may be electrically connected to the first node N1. A gate electrode of the second transistor T2 may be electrically connected to the scan line Si. The first terminal and the second terminal of the second transistor T2 are different terminals, and, for example, if the first terminal is a drain electrode, the second terminal may be a source electrode.

In case that a scan signal having a gate-on voltage (e.g., a high level voltage) is supplied from the scan line Si, the second transistor T2 may be turned on to electrically connect the data line Dj with the first node N1. The first node N1 may be a point at which the second terminal of the second transistor T2 and the gate electrode of the first transistor T1 are electrically connected to each other. The second transistor T2 may transmit a data signal to the gate electrode of the first transistor T1.

The third transistor T3 may obtain a sensing signal through the sensing line SENj by electrically connecting the first transistor T1 to the sensing line SENj, and detect, using the sensing signal, characteristics of the pixel PXL such as a threshold voltage of the first transistor T1. Information about the characteristics of the pixel PXL may be used to convert image data such that a deviation in characteristic between pixels PXL may be compensated for. A second terminal of the third transistor T3 may be electrically connected to the second terminal of the first transistor T1. A first terminal of the third transistor T3 may be electrically connected to the sensing line SENj. A gate electrode of the third transistor T3 may be electrically connected to the control line CLi. Furthermore, the first terminal of the third transistor T3 may be electrically connected to an initialization power supply. The third transistor T3 may be an initialization transistor configured to initialize the second node N2, and may be turned on in case that a sensing control signal is supplied thereto from the control line CLi, so that the voltage of the initialization power supply may be transmitted to the second node N2. Hence, a second storage electrode UE of the storage capacitor Cst that is electrically connected to the second node N2 may be initialized.

The storage capacitor Cst may include a first storage electrode LE and a second storage electrode UE. A first storage electrode LE of the storage capacitor Cst may be electrically connected to the first node N1. A second storage electrode UE of the storage capacitor Cst may be electrically connected to the second node N2. The storage capacitor Cst may be charged with a data voltage corresponding to a data signal to be supplied to the first node N1 during one frame period. Hence, the storage capacitor Cst may store a voltage corresponding to a difference between a voltage of the gate electrode of the first transistor T1 and a voltage of the second node N2.

Although FIG. 4 illustrates implementations in which all of the light emitting elements LD that form the emission component EMU are electrically connected in parallel to each other, the present disclosure is not limited thereto. The emission component EMU may have a series/parallel combination structure in which a plurality of series sets each including a plurality of light emitting elements LD that are electrically connected in parallel to each other are electrically connected to each other. The emission component EMU having a series/parallel combination structure will be described with reference to FIG. 5.

Referring to FIG. 5, the emission component EMU may include at least one series set. Each series set may include a pair of electrodes (e.g., two electrodes), and at least one light emitting element LD electrically connected in a forward direction between the pair of electrodes. Here, the number of series sets that form the emission component EMU and the number of light emitting elements LD that form each series set are not particularly limited. For example, the numbers of light emitting elements LD that form the respective series sets may be identical to or different from each other. The number of light emitting elements LD of each series set is not particularly limited.

For example, the emission circuit EMU may include a first series set SET1 including at least one first light emitting element LD1, and a second series set SET2 including at least one second light emitting element LD2.

The first series set SET1 may include a first electrode PE1, an intermediate electrode CTE (or a bridge electrode), and at least one first light emitting element LD1 electrically connected between the first electrode PE1 and the intermediate electrode CTE. Each first light emitting element LD1 may be electrically connected in the forward direction between the first electrode PE1 and the first intermediate electrode CTE. For example, the first end EP1 of the first light emitting element LD1 may be electrically connected to the first electrode PE1. The second end EP2 of the first light emitting element LD1 may be electrically connected to the intermediate electrode CTE. The first series set SET1 may further include at least one invalid light source, e.g., a reverse light emitting element LDr, as well as including the first light emitting element LD1 that forms each valid light source.

The second series set SET2 may include the intermediate electrode CTE, a second electrode PE2, and at least one second light emitting element LD2 electrically connected between the intermediate electrode CTE and the second electrode PE2. Each second light emitting element LD2 may be electrically connected in the forward direction between the intermediate electrode CTE and the second electrode PE2. For example, the first end EP1 of the second light emitting element LD2 may be electrically connected to the intermediate electrode CTE. The second end EP2 of the second light emitting element LD2 may be electrically connected to the second electrode PE2. The second series set SET2 may further include at least one invalid light source, e.g., a reverse light emitting element LDr, as well as including the second light emitting element LD2 that forms each valid light source.

The first electrode of the emission component EMU, e.g., the first electrode PE1, may be an anode of the emission component EMU. The last electrode of the emission component EMU, e.g., the second electrode PE2, may be a cathode of the emission component EMU.

In case that the light emitting elements LD are electrically connected to have a series/parallel structure, power efficiency may be enhanced, compared to the case where an equal number of light emitting elements LD are electrically connected only in parallel to each other. Furthermore, in the pixel PXL in which the light emitting elements LD are electrically connected to have a series/parallel structure, sufficient luminance may be expressed by the light emitting elements LD of some series stages, so that the probability of occurrence of a black spot defect in the pixel PXL may be reduced.

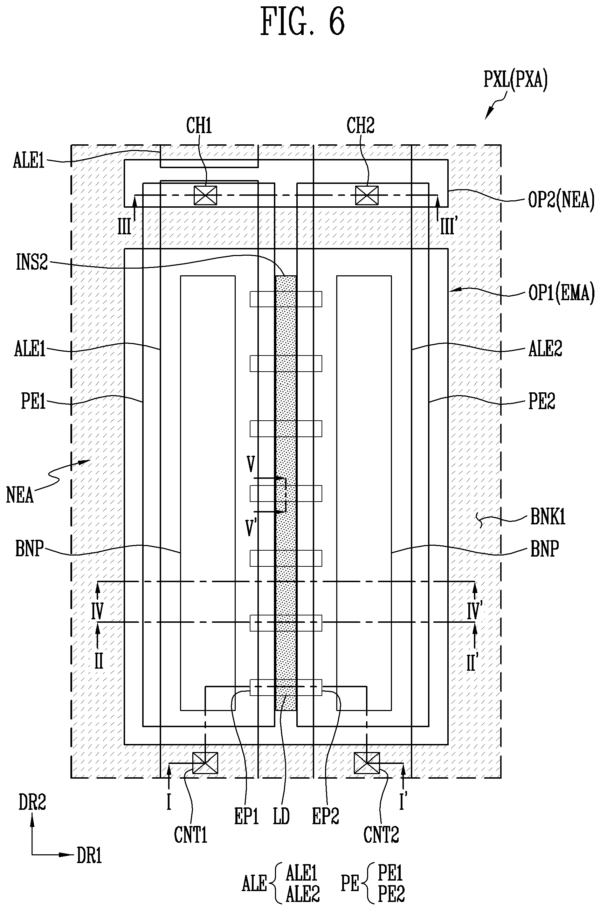

FIG. 6 is a schematic plan view illustrating the display element layer of the pixel PXL.

In FIG. 6, for convenience of description, illustration of the transistors electrically connected to the light emitting elements LD and the signal lines electrically connected to the transistors is omitted.

In the following, not only the components included in the pixel PXL illustrated in FIG. 6 but also an area in which the components are provided (or located) may be embraced in the definition of the term "pixel PXL".

Referring to FIGS. 1 to 6, the pixel PXL may be disposed in a pixel area PXA defined (or provided) on the display area DA of the substrate SUB. The pixel area PXA may include an emission area EMA and a non-emission area NEA.

The pixel PXL may include a first bank BNK1 located in the non-emission area NEA, and light emitting elements LD located in the emission area EMA.

The first bank BNK1 may be a structure for defining (or partitioning) the respective emission areas EMA of the pixel PXL and pixels PXL adjacent thereto and, for example, may be a pixel defining layer. The first bank BNK1 may be a pixel defining layer or a dam structure for defining each emission area EMA to which the light emitting elements LD are to be supplied, during a process of supplying (or inputting) the light emitting elements LD to the pixel PXL. For example, because the emission area EMA of the pixel PXL is defined by the first bank BNK1, a mixed solution (e.g., ink) including a target amount and/or type of light emitting elements LD may be supplied (or input) to the emission area EMA.

The first bank BNK1 may include at least one light blocking material and/or reflective material (or scattering material), thus preventing a light leakage defect in which light leaks between the pixel PXL and the pixels PXL adjacent thereto. The first bank BNK1 may include transparent material (or substance). The transparent material may include, for example, polyamides resin, polyimides resin, and the like, but the present disclosure is not limited thereto. In order to enhance the efficiency of light emitted from the pixel PXL, a separate reflective material layer may be provided and/or formed on the first bank BNK1.

The first bank BNK1 may include, in the pixel area PXA, at least one opening OP through which components disposed thereunder are exposed. For example, the first bank BNK1 may include a first opening OP1 and a second opening OP2 that expose components disposed under the first bank BNK1 in the pixel area PXA. The emission area EMA of the pixel PXL and the first opening OP1 of the first bank BNK1 may correspond to each other.

In the pixel area PXA, the second opening OP2 may be disposed at a position spaced from the first opening OP1, and disposed adjacent to one side of the pixel area PXA, e.g., an upper side of the pixel area PXA. The second opening OP2 may be an electrode separation area where at least one alignment electrode ALE is separated from at least one alignment electrode ALE provided in pixels PXL adjacent thereto in a second direction DR2, but the present disclosure is not limited thereto.

The pixel PXL may include electrodes PE provided in at least the emission area EMA, light emitting elements LD electrically connected to the electrodes PE, and bank patterns BNP and alignment electrodes ALE that are provided at positions corresponding to the electrodes PE. For example, the pixel PXL may include first and second electrodes PE1 and PE2, light emitting elements LD, first and second alignment electrodes ALE1 and ALE2, and bank patterns BNP, which are provided in at least the emission area EMA. The electrodes PE and/or the alignment electrodes ALE each may be changed in number, shape, size, arrangement structure, etc. in various ways depending on the structure of the pixel PXL (particularly, the emission component EMU).

Based on one surface of the substrate SUB on which the pixel PXL is provided, the bank patterns BNP, the alignment electrodes ALE, the light emitting elements LD, and the electrodes PE may be provided in the order listed, but the present disclosure is not limited thereto. The positions, the formation sequence, and the like of the components included in the pixel PXL (or the emission component EMU) may be changed in various ways. Detailed description of a stacked structure (or a cross-section structure) of the pixel PXL will be made below with reference to FIGS. 7 to 16.

The bank patterns BNP may be provided in at least the emission area EMA, and may be spaced from each other with respect to a first direction DR1 in the emission area EMA, and each may extend in the second direction DR2. The bank patterns BNP may be provided at positions corresponding to the respective alignment electrodes ALE.

The bank pattern BNP (referred also to as "wall pattern", "protrusion pattern", "support pattern", or "wall structure") may have a uniform width in the emission area EMA. For example, the bank pattern BNP may have a bar-like shape having a certain width with respect to an extension direction thereof in the emission area EMA, in a plan view, but the present disclosure is not limited thereto.

The bank pattern BNP may be located under each of the first and second alignment electrodes ALE1 and ALE2 and support each of the first and second alignment electrodes ALE1 and ALE2 to change a surface profile (or a surface shape) of each of the first and second alignment electrodes ALE1 and ALE2 so that light emitted from the light emitting elements LD may be guided in an image display direction (or a frontal direction or a thickness direction of the substrate SUB, e.g., a third direction DR3) of the display device DD.

The bank pattern BNP may overlap the corresponding alignment electrode ALE in at least the emission area EMA. For example, the bank pattern BNP may overlap each of the first and second alignment electrodes ALE1 and ALE2 in at least the emission area EMA. The bank pattern BNP along with the first and second alignment electrodes ALE1 and ALE2 may function as a structure for accurately defining (or providing) an alignment position of the light emitting elements LD in the emission area EMA of the pixel PXL.

Because the bank pattern BNP is provided under one area of each of the alignment electrodes ALE, the one area of each of the alignment electrodes ALE may protrude in an upward direction of the pixel PXL in the area where the bank pattern BNP is formed. In this way, the bank pattern BNP, which is a wall structure, may be formed around the light emitting elements LD. For example, the bank pattern BNP, which is a wall structure, may be formed in the emission area EMA and oppose the first or second ends EP1 or EP2 of the light emitting elements LD.

In the case in which the bank pattern BNP and/or the alignment electrodes ALE include reflective material, a reflective wall structure may be formed around the light emitting elements LD. Hence, light emitted from the light emitting elements LD may be oriented in an upward direction of the pixel PXL (e.g., in the image display direction of the display device DD, e.g., the third direction DR3), so that the light emission efficiency of the pixel PXL may be further improved.

The alignment electrodes ALE may be disposed in at least the emission area EMA, and may be spaced from each other with respect to the first direction DR1 in the emission area EMA, and each may extend in the second direction DR2. The alignment electrodes ALE may include the first alignment electrode ALE1 and the second alignment electrode ALE2 that are spaced from each other in the first direction DR1.

At least one of the first alignment electrode ALE1 or the second alignment electrode ALE2 may be separated from other electrodes (e.g., an alignment electrode ALE provided in each of pixels PXL adjacent thereto in the second direction DR2) in the second opening OP2 (e.g., an electrode separation area) of the first bank BNK1 after the light emitting elements LD are supplied to and aligned in the pixel area PXA during a process of fabricating the pixel PXL (or the display device DD). For example, one end of the first alignment electrode ALE1 may be separated, in the second opening OP2, from the first alignment electrode ALE1 of the pixel PXL that is disposed on an upper side of the corresponding pixel PXL in the second direction DR2.

The first alignment electrode ALE1 may be electrically connected, through a first contactor CNT1, to the pixel circuit PXC described with reference to FIGS. 4 and 5. The first contactor CNT1 may be formed by removing a portion of at least one insulating layer located between the first alignment electrode ALE1 and the pixel circuit PXC. Some components of the pixel circuit PXC may be exposed through the first contactor CNT1. The second alignment electrode ALE2 may be electrically connected, through a second contactor CNT2, to the second power line PL2 (or the second driving power supply VSS) described with reference to FIGS. 4 and 5. The second contactor CNT2 may be formed by removing a portion of at least one insulating layer located between the second alignment electrode ALE2 and the second power line PL2. A portion of the second power line PL2 may be exposed through the second contactor CNT2.

The first contactor CNT1 and the second contactor CNT2 may be disposed in the non-emission area NEA and overlap the first bank BNK1. The present disclosure is not limited thereto. The first and second contactors CNT1 and CNT2 may be disposed in the emission area EMA or the second opening OP2 of the first bank BNK1.

The first alignment electrode ALE1 may be electrically connected to the first electrode PE1 through the first contact hole CH1 in the non-emission area NEA. The second alignment electrode ALE2 may be electrically connected to the second electrode PE2 through the second contact hole CH2 in the non-emission area NEA.

Each of the first alignment electrode ALE1 and the second alignment electrode ALE2 may be supplied with a signal (e.g., an alignment signal) from an alignment pad located in the non-display area NDA at the step of aligning the light emitting elements LD. For example, the first alignment electrode ALE1 may be supplied with a first alignment signal from a first alignment pad. The second alignment electrode ALE2 may be supplied with a second alignment signal from a second alignment pad. The foregoing first and second alignment signals may be signals each having a voltage difference and/or a phase difference enabling the light emitting elements LD to be aligned between the first and second alignment electrodes ALE1 and ALE2. At least one of the first alignment signal or the second alignment signal may be an AC signal, but the present disclosure is not limited thereto.

Each alignment electrode ALE may have a bar-like shape having a uniform width with respect to the second direction DR2, but the present disclosure is not limited thereto. Each alignment electrode ALE may or may not have a bent portion in the non-emission area NEA and/or the second opening OP2 of the first bank BNK1 that is an electrode separation area, and the shape and/or size thereof in areas other than the emission area EMA may be changed in various ways rather than being particularly limited.

Although at least two to several tens of light emitting elements LD may be aligned and/or disposed in the emission area EMA (or the pixel area PXA), the number of light emitting elements LD is not limited thereto. The number of light emitting elements LD aligned and/or disposed in the emission area EMA may be changed in various ways.

The light emitting elements LD each may be disposed between the first alignment electrode ALE1 and the second alignment electrode ALE2. In a plan view, each of the light emitting elements LD may include a first end EP1 and a second end EP2 that are located (or face each other) on respective opposite ends of the light emitting element LD in the longitudinal direction thereof, e.g., in the first direction DR1. The second semiconductor layer (refer to "13" of FIG. 1) including a p-type semiconductor layer may be disposed on the first end EP1 (or the p-type end), and the first semiconductor layer (refer to "11" of FIG. 1) including an n-type semiconductor layer may be disposed on the second end EP2 (or the n-type end).

The light emitting elements LD may be disposed at positions spaced from each other and aligned in substantially parallel to each other. A distance by which the light emitting elements LD are spaced from each other is not particularly limited. A plurality of light emitting elements LD may be disposed adjacent to each other to form a group, and a plurality of additional light emitting elements LD may be spaced from each other at regular intervals to form a group. The light emitting elements LD may be aligned in one direction with an uneven density.

The light emitting elements LD may be input (or supplied) to the pixel area PXA (or the emission area EMA) by an inkjet printing scheme, a slit coating scheme, or other various schemes. For example, the light emitting elements LD may be mixed with a volatile solvent and then inputted to the pixel area PXA by an inkjet printing scheme or a slit coating scheme. If the first alignment electrode ALE1 and the second alignment electrode ALE2 are respectively supplied with corresponding alignment signals, an electric field may be formed between the first alignment electrode ALE1 and the second alignment electrode ALE2. Consequently, the light emitting elements LD may be aligned between the first alignment electrode ALE1 and the second alignment electrode ALE2. After the light emitting elements LD are aligned, the solvent may be removed by a volatilization scheme or other schemes. In this way, the light emitting elements LD may be reliably aligned between the first alignment electrode ALE1 and the second alignment electrode ALE2.

The electrodes PE (or the pixel electrodes) may be provided in at least the emission area EMA, and each may be provided at a position corresponding to at least one alignment electrode ALE and the light emitting element LD. For example, each of the electrodes PE may be formed on the corresponding alignment electrode ALE and the corresponding light emitting elements LD to overlap the corresponding alignment electrode ALE and the corresponding light emitting elements LD, and thus electrically connected to at least the light emitting elements LD.

The electrodes PE may include a first electrode PE1 and a second electrode PE2 that are spaced from each other.

The first electrode PE1 (referred also to as "first pixel electrode" or "anode") may be formed on the first alignment electrode ALE1 and the respective first ends EP1 of the light emitting elements LD, and thus electrically connected to the respective first ends EP1 of the light emitting elements LD. Furthermore, the first electrode PE1 may directly contact the first alignment electrode ALE1 through the first contact hole CH1 in at least the non-emission area NEA, e.g., the second opening OP2 of the first bank BNK1 that is an electrode separation area, and may be electrically and/or physically connected with the first alignment electrode ALE1. The first contact hole CH1 may be formed by removing a portion of at least one insulating layer disposed between the first electrode PE1 and the first alignment electrode ALE1. A portion of the first alignment electrode ALE1 may be exposed through the first contact hole CH1. Although the first contact hole CH1 that is a connection point (or a contact point) between the first electrode PE1 and the first alignment electrode ALE1 has been described as being located in the second opening OP2 of the first bank BNK1 (or in the non-emission area NEA), the present disclosure is not limited thereto. The connection point (or the contact point) between the first electrode PE1 and the first alignment electrode ALE1 may be located in the emission area EMA of the pixel PXL.

The pixel circuit PXC, the first alignment electrode ALE1, and the first electrode PE1 may be electrically connected to each other through the first contactor CNT1 and the first contact hole CH1.

Although in the foregoing the first alignment electrode ALE1 and the first electrode PE1 have been described as directly contacting each other through the first contact hole CH1, the present disclosure is not limited thereto. To prevent a defect due to material characteristics of the first alignment electrode ALE1 from occurring, the first electrode PE1 may directly contact the pixel circuit PXC rather than directly contacting the first alignment electrode ALE1, and may be electrically connected to the pixel circuit PXC.

The first electrode PE1 may have a bar-like shape extending in the second direction DR2, but the present disclosure is not limited thereto. The shape of the first electrode PE1 may be changed in various ways so long as the first pixel electrode PE1 may be electrically and/or physically reliably connected with the first ends EP1 of the light emitting elements LD. Furthermore, the shape of the first electrode PE1 may be changed in various ways, e.g., taking into account the disposition and connection relationship with the first alignment electrode AEL1 disposed thereunder.

The second electrode PE2 (referred also to as "second pixel electrode" or "cathode") may be formed on the second alignment electrode ALE2 and the respective second ends EP2 of the light emitting elements LD, and thus electrically connected to the respective second ends EP2 of the light emitting elements LD. Furthermore, the second electrode PE2 may directly contact the second alignment electrode ALE2 through the second contact hole CH2 and may be electrically and/or physically connected with the second alignment electrode ALE2. The second contact hole CH2 may be formed by removing a portion of at least one insulating layer disposed between the second electrode PE2 and the second alignment electrode ALE2. A portion of the second alignment electrode ALE2 may be exposed through the second contact hole CH2. The second contact hole CH2 that is a connection point (or a contact point) between the second electrode PE2 and the second alignment electrode ALE2 may be located in the emission area EMA of the pixel PXL.

The second power line PL2, the second alignment electrode ALE2, and the second electrode PE2 may be electrically connected to each other through the second contactor CTN2 and the second contact hole CH2.

Although in the foregoing the second alignment electrode ALE2 and the second electrode PE2 have been described as directly contacting each other through the second contact hole CH2, the present disclosure is not limited thereto. To prevent a defect due to material characteristics of the second alignment electrode ALE2 from occurring, the second electrode PE2 may directly contact the second power line PL2 rather than directly contacting the second alignment electrode ALE2, and may be electrically connected to the second power line PL2.

The second electrode PE2 may have a bar-like shape extending in the second direction DR2, but the present disclosure is not limited thereto. The shape of the second electrode PE2 may be changed in various ways so long as the second pixel electrode PE2 may be electrically and/or physically reliably connected with the second ends EP2 of the light emitting elements LD. Furthermore, the shape of the second electrode PE2 may be changed in various ways, e.g., taking into account the disposition and connection relationship with the second alignment electrode AEL2 disposed thereunder.

The first electrode PE1 and the second electrode PE2 may be spaced from each other with a second insulating layer INS2 interposed therebetween.

The second insulating layer INS2 may overlap the light emitting elements LD and may be disposed between the first electrode PE1 and the second electrode PE2. The second insulating layer INS2 may be located on the light emitting elements LD to partially cover the outer surface (e.g., the outer peripheral or circumferential surface or the surface) of each of the light emitting elements LD such that the first end EP1 and the second end EP2 of each of the light emitting elements LD may be exposed to the outside.

Hereinafter, the stacked structure (or the cross-sectional structure) of the pixel PXL in accordance with the foregoing will be mainly described with reference to FIGS. 7 to 16.

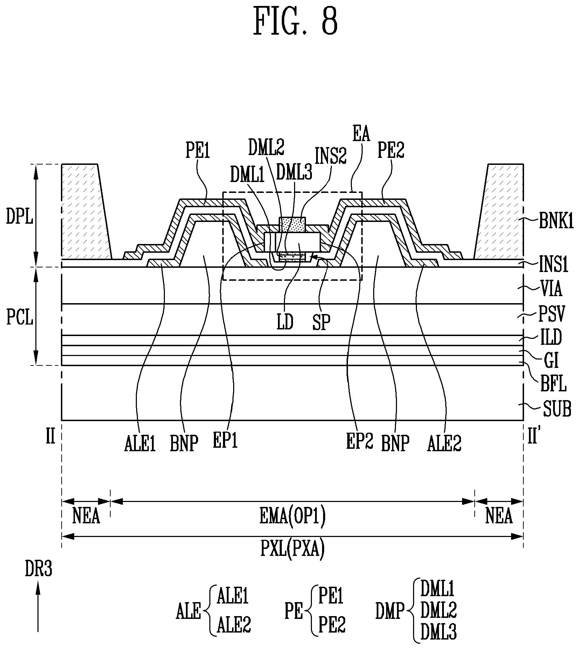

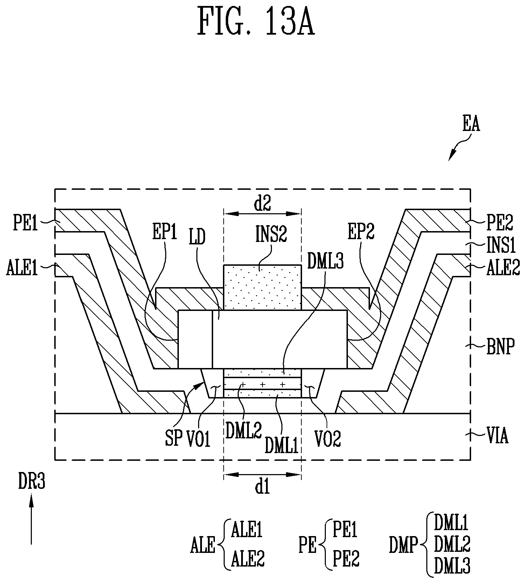

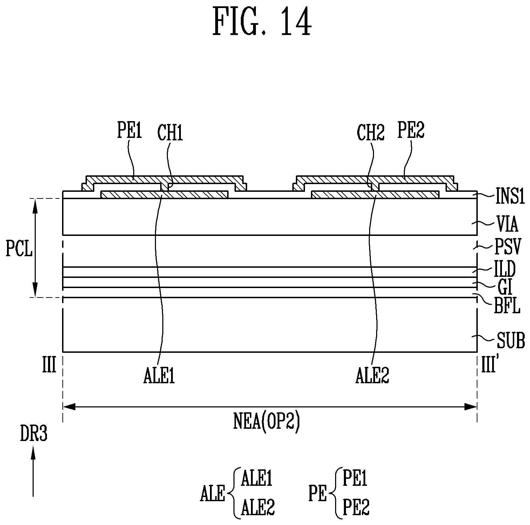

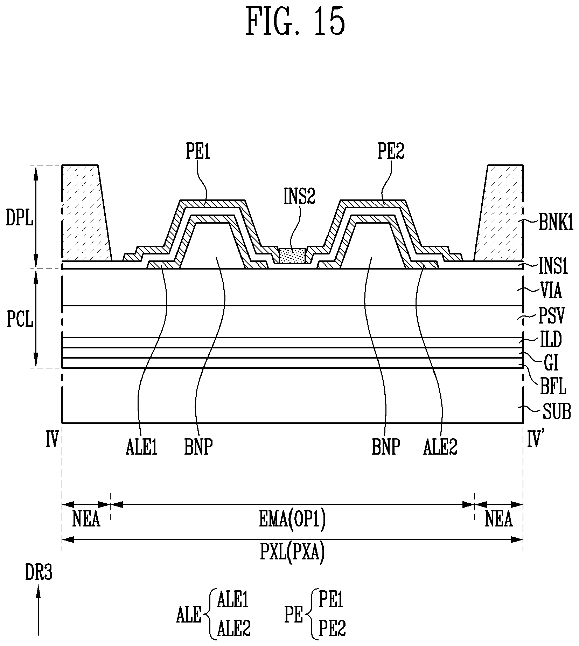

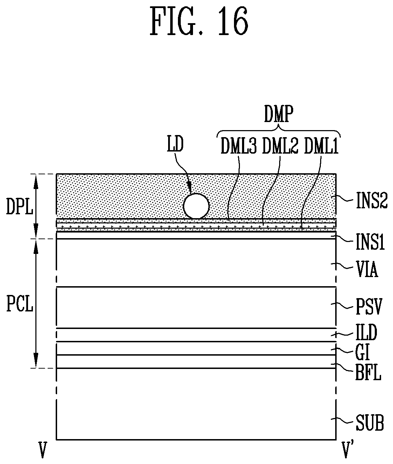

FIG. 7 is a schematic cross-sectional view taken along the line I-I' of FIG. 6. FIGS. 8 to 12 are schematic cross-sectional views taken along the line II-II' of FIG. 6. FIGS. 13A to 13D are schematic enlarged views of a portion EA of FIG. 8. FIG. 14 is a schematic cross-sectional view taken along the line III-III' of FIG. 6. FIG. 15 is a schematic cross-sectional view taken along the line IV-IV' of FIG. 6. FIG. 16 is a schematic cross-sectional view taken along the line V-V' of FIG. 6.

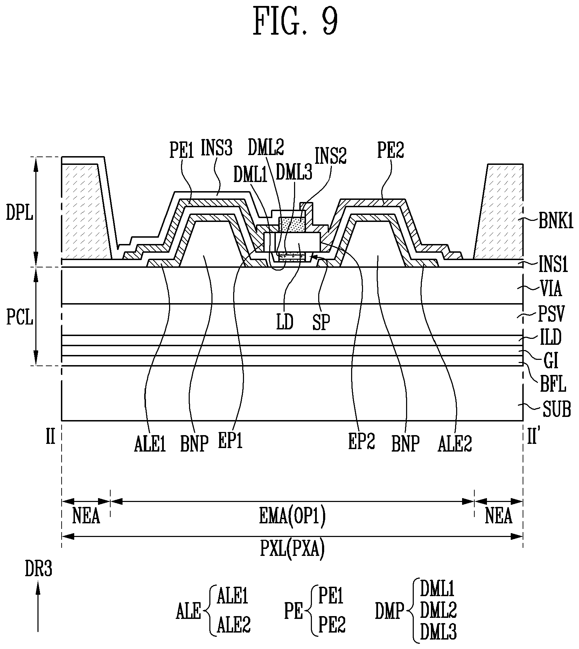

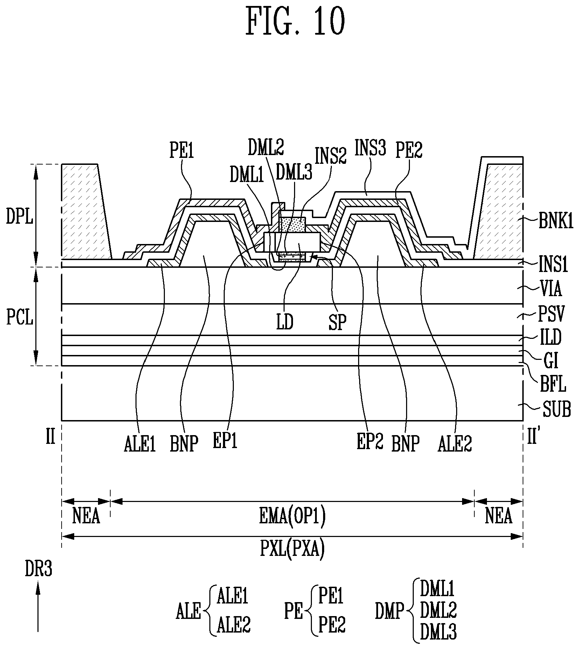

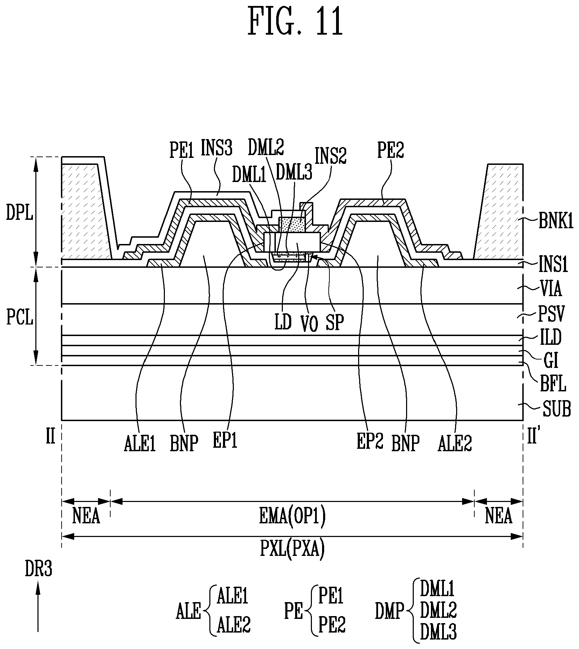

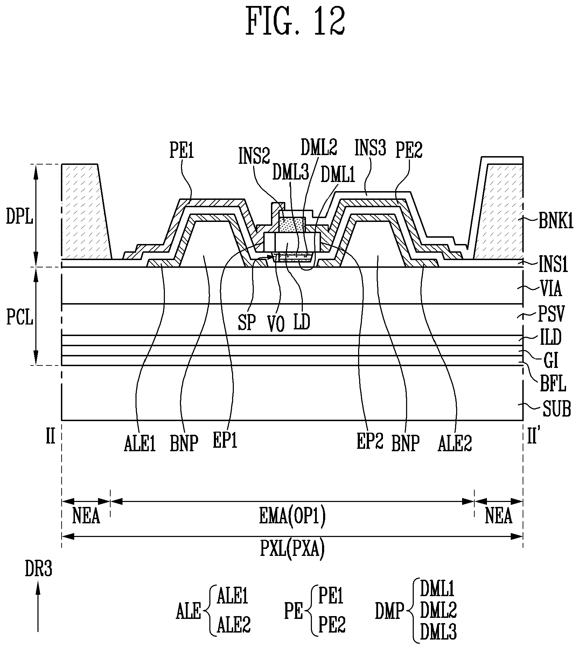

FIGS. 9 to 12 refer to modifications of FIG. 8 pertaining both to the step of forming the first electrode PE1 and the second electrode PE2 and to whether a third insulating layer INS3 is present. For example, FIGS. 9 and 11 illustrate implementations in which the second electrode PE2 is formed after the first electrode PE1 and the third insulating layer INS3 are formed, and FIGS. 10 and 12 illustrate implementations in which the first electrode PE1 is formed after the second electrode PE2 and the third insulating layer INS3 are formed.

Although FIGS. 7 to 16 simply illustrate the stacked structure (or the cross-sectional structure) of the pixel PXL, e.g., illustrating that each electrode is formed of a single-layered electrode and each insulating layer is formed of a single insulating layer, the present disclosure is not limited thereto.

The following description related to FIGS. 7 to 16 will be focused on differences from the above-mentioned implementations so as to avoid redundant description.

Referring to FIGS. 1 to 16, the pixel PXL may include a substrate SUB, a pixel circuit layer PCL, and a display element layer DPL.

The pixel circuit layer PCL and the display element layer DPL may be disposed on one surface of the substrate SUB and overlap each other. For example, the display area DA of the substrate SUB may include the pixel circuit layer PCL disposed on the one surface of the substrate SUB, and the display element layer DPL disposed on the pixel circuit layer PCL. However, relative positions of the pixel circuit layer PCL and the display element layer DPL on the substrate SUB may be changed. In case that the pixel circuit layer PCL and the display element layer DPL are separated from each other as separate layers and overlap each other, layout space sufficient to form each of the pixel circuit PXC and the emission component EMU on a plane may be secured.

The substrate SUB may include transparent insulating material to allow light transmission. The substrate SUB may be a rigid substrate or a flexible substrate. The substrate SUB may be the substrate SUB described with reference to FIG. 3.

In each pixel area PXA of the pixel circuit layer PCL, circuit elements (e.g., transistors T) for forming the pixel circuit PXC of the corresponding pixel PXL and signal lines electrically connected to the circuit elements may be disposed. Furthermore, the alignment electrodes ALE, the light emitting elements LD, and/or the electrodes PE that form the emission component EMU of the corresponding pixel PXL may be disposed in each pixel area PXA of the display circuit layer DPL.

The pixel circuit layer PCL may include at least one or more insulating layers as well as including the circuit elements and the signal lines. For example, the pixel circuit layer PCL may include a buffer layer BFL, a gate insulating layer GI, an interlayer insulating layer ILD, a passivation layer PSV, and a via layer VIA that are successively stacked on the substrate SUB in a third direction DR3.

The buffer layer BFL may be disposed on the overall surface of the substrate SUB. The buffer layer BFL may prevent impurities from diffusing into the transistors T included in the pixel circuit PXC. The buffer layer BFL may be an inorganic insulating layer including inorganic material. The buffer layer BFL may include at least one of silicon nitride (SiNₓ), silicon oxide (SiOₓ), silicon oxynitride (SiOₓN_{y}), or aluminum oxide (AlOₓ). Although the buffer layer BFL may be provided in a single-layer structure, the buffer layer BFL may be provided in a multi-layer structure having at least two or more layers. In the case where the buffer layer BFL has a multi-layer structure, the respective layers may be formed of the same material or different materials. The buffer layer BFL may be omitted depending on the material of the substrate SUB or processing conditions.

The gate insulating layer GI may be disposed on the overall surface of the buffer layer BFL. The gate insulating layer GI may include the same material as that of the buffer layer BFL, or include suitable (or selected) material from among the materials discussed as the constituent materials of the buffer layer BFL. The gate insulating layer GI may be an inorganic insulating layer including inorganic material.

The interlayer insulating layer ILD may be provided and/or formed on the overall surface of the gate insulating layer GI. The interlayer insulating layer ILD may include the same material as that of the buffer layer BFL, or include suitable (or selected) material from among the materials discussed as the constituent materials of the buffer layer BFL.

The passivation layer PSV may be provided and/or formed on the overall surface of the interlayer insulating layer ILD. The passivation layer PSV may include the same material as that of the buffer layer BFL, or include one or more suitable (or selected) materials from among the materials discussed as the constituent materials of the buffer layer BFL. The passivation layer PSV may be an inorganic insulating layer including inorganic material or an organic insulating layer including organic material.

The via layer VIA may be provided and/or formed on the overall surface of the passivation layer PSV. The via layer VIA may be an inorganic insulating layer including inorganic material or an organic insulating layer including organic material. The inorganic insulating layer may include, for example, at least one of silicon oxide (SiOₓ), silicon nitride (SiNₓ), or silicon oxynitride (SiOₓN_{y}), or may include at least one of metal oxides such as aluminum oxide (AlOₓ). The organic insulating layer may include, for example, at least one of polyacrylic resin, epoxy resin, phenolic resin, polyamide resin, polyimide rein, unsaturated polyester resin, poly-phenylen ether resin, poly-phenylene sulfide resin, or benzocyclobutene resin. The via layer VIA may be an organic insulating layer.

The via layer VIA may include a first contactor CNT1 and a second contactor CNT2. For example, the via layer VIA may be partially open to include the first and second contactors CNT1 and CNT2. The via layer VIA may be used as a planarization layer formed to mitigate a step difference that occurs due to components of the pixel circuit PXC that are disposed under the via layer VIA in the pixel circuit layer PCL.

At least one transistor T may be disposed in the pixel circuit layer PCL. The transistor T may include a driving transistor configured to control driving current of the light emitting element LD. The transistor T may be the first transistor T1 of the pixel circuit PXC described with reference to FIGS. 4 and 5.

The transistor T may include a semiconductor pattern and a gate electrode GE that overlaps at least a portion of the semiconductor pattern. The semiconductor pattern may include a channel area ACT, a first contact area SE, and a second contact area DE. The first contact area may be a source area. The second contact area DE may be a drain area.

The gate electrode GE may be provided and/or formed on the gate insulating layer GI and correspond to the channel area ACT of the semiconductor pattern. The gate electrode GE may be disposed between the gate insulating layer GI and the interlayer insulating layer ILD. The gate electrode GE may be provided on the gate insulating layer GI and overlap the channel area ACT in the third direction DR3.

The semiconductor pattern may be provided and/or formed on the buffer layer BFL. The channel area ACT, the first contact area SE, and the second contact area DE each may be a semiconductor pattern formed of poly silicon, amorphous silicon, an oxide semiconductor, or the like. The channel area ACT, the first contact area SE, and the second contact area DE each may be formed of an undoped semiconductor layer or a semiconductor layer doped with an impurity. For example, each of the first contact area SE and the second contact area DE may be formed of a semiconductor layer doped with an impurity. The channel area ACT may be formed of an undoped semiconductor layer.

The channel area ACT of the transistor T may overlap the gate electrode GE of the transistor T in the third direction DR3.

The first contact area SE of the transistor T may contact one end of the channel area ACT, and may be electrically connected to a bridge pattern BRP by a first connector TE1.

The first connector TE1 may be provided and/or formed on the interlayer insulating layer ILD. One end of the first connector TE1 may be electrically and/or physically connected to the first contact area SE of the transistor T through a contact hole that successively passes through the interlayer insulating layer ILD and the gate insulating layer GI. Furthermore, a remaining end of the first connector TE1 may be electrically and/or physically connected to the bridge pattern BRP through a contact hole that successively passes through the passivation layer PSV disposed on the interlayer insulating layer ILD.

The bridge pattern BRP may be provided and/or formed on the passivation layer PSV. One end of the bridge pattern BRP may be electrically connected to the first contact area SE of the transistor T by the first connector TE1. Furthermore, a remaining end of the bridge pattern BRP may be electrically and/or physically connected with a bottom metal pattern BML through a contact hole that successively passes through the passivation layer PSV, the interlayer insulating layer ILD, the gate insulating layer GI, and the buffer layer BFL. The bottom metal pattern BML and the first contact area SE of the transistor T may be electrically connected to each other by the bridge pattern BRP and the first connector TE1.

The bridge pattern BRP may be electrically connected to a component of the display element layer DPL, e.g., to the first alignment electrode ALE1, through the first contactor CNT1 passing through the via layer VIA.

The bottom metal pattern BML may be a first conductive layer disposed between the substrate SUB and the buffer layer BFL. The bottom metal pattern BML may be electrically connected to the transistor T. In this case, a driving range of a voltage to be supplied to the gate electrode GE of the transistor T may be increased. The bottom metal pattern BML may be electrically connected to the first contact area SE of the transistor T and stabilize the channel area of the transistor T. Furthermore, because the bottom metal pattern BML is electrically connected to the transistor T, the bottom metal pattern BML may be prevented from floating.

The bottom metal pattern BML may have a single layer structure formed of one or combination selected from the group consisting of copper (Cu), molybdenum (Mo), tungsten (W), aluminum neodymium (AlNd), titanium (Ti), aluminum (Al), silver (Ag), and an alloy thereof, or may have a double layer or multilayer structure formed of molybdenum (Mo), titanium (Ti), copper (Cu), aluminum (Al), or silver (Ag) to reduce line resistance.

The second contact area DE of the transistor T may be connected to a remaining end of the channel area ACT, and may be electrically connected to the second connector TE2.

The second connection component TE2 may be provided and/or formed on the interlayer insulating layer ILD. The second connector TE2 may be electrically connected to the second contact area DE of the transistor T through a contact hole that passes through the interlayer insulating layer ILD and the gate insulating layer GI. Furthermore, the second connector TE2 may be electrically connected to the second transistor T2 described with reference to FIGS. 4 and 5.

Although in the foregoing there has been illustrated the case where the transistor T is a thin-film transistor having a top gate structure, the present disclosure is not limited thereto. The structure of the transistor T may be changed in various ways.

The passivation layer PSV may be disposed on the transistor T and the first and second connectors TE1 and TE2.

The pixel circuit layer PCL may include a power line disposed on the passivation layer PSV. For example, the pixel circuit layer PCL may include a second power line PL2 disposed on the passivation layer PSV. A voltage of the second driving power supply VSS may be applied to the second power line PL2. The pixel circuit layer PCL may further include the first power line PL1 described with reference to FIGS. 4 and 5. The first power line PL1 may be formed through the same process as that of the second power line PL2 and may be provided at the same layer as the second power line PL2, or may be formed through a process different from that of the second power line PL2 and may be provided at a layer different from the second power line PL2. The present disclosure is not limited thereto.

The via layer VIA may be provided and/or formed on the bridge pattern BRP and the second power line PL2. The via layer VIA may be partially open to include the first contactor CNT1 through which a portion of the bridge pattern BRP is exposed, and the second contactor CNT2 through which a portion of the second power line PL2 is exposed.

The display element layer DPL may be disposed on the via layer VIA.

The display element layer DPL may include bank patterns BNP, alignment electrodes ALE, a first bank BNK1, light emitting elements LD, and electrodes PE.

The bank patterns BNP may be disposed on the via layer VIA. For example, the bank patterns BNP may protrude in the third direction DR3 on one surface of the via layer VIA. In this case, one area of each of the alignment electrodes ALE disposed on the bank patterns BNP may protrude in the third direction DR3 (or in the thickness direction of the substrate SUB).

The bank patterns BNP may include an inorganic insulating layer including inorganic material or an organic insulating layer including organic material. The bank patterns BNP may include an organic insulating layer having a single layer structure and/or an inorganic insulating layer having a single layer structure, but the present disclosure is not limited thereto. The bank patterns BNP may be provided in a multi-layer structure formed by stacking at least one or more organic insulating layers and at least one or more inorganic insulating layers. However, the material of the bank patterns BNP is not limited to the foregoing. The bank patterns BNP may include conductive material (or conductive substance).

The bank patterns BNP may be located under each of the first and second alignment electrodes ALE1 and ALE2 in at least the emission area EMA and overlap the corresponding alignment electrode ALE.

The bank patterns BNP may have a trapezoidal cross-section that is reduced in width from one surface (or an upper surface) of the via layer VIA upward in the third direction DR3, but the present disclosure is not limited thereto. The bank patterns BNP may include a cross-sectional shape such as a semi-elliptical shape or a semi-circular shape (or a hemispherical shape) that is reduced in width from one surface of the via layer VIA upward in the third direction DR3. The shape of the bank patterns BNP is not limited to the foregoing examples, and may be changed in various ways within a range in which the efficiency of light emitted from each of the light emitting elements LD may be enhanced.

The bank patterns BNP may be used as a reflector. For example, the bank patterns BNP, along with the alignment electrodes ALE disposed thereover, may be used as a reflector to guide light emitted from each light emitting element LD in the image display direction of the display device DD, so that the light output efficiency of the pixel PXL may be enhanced.

The alignment electrodes ALE may be disposed on the bank pattern BNP.

The alignment electrodes ALE may be disposed on the same plane and have the same thickness with respect to the third direction DR3. The alignment electrodes ALE may be concurrently (e.g., simultaneously) or successively formed through the same process.

The alignment electrodes ALE may be formed of a material having a reflectivity to allow light emitted from the light emitting elements LD to travel in the image display direction (or a frontal direction) of the display device DD. For example, the alignment electrodes ALE may be formed of a conductive material (or substance). The conductive material may include opaque metal that is suitable for reflecting, in the image display direction of the display device DD, light emitted from the light emitting elements LD. For example, the opaque metal may include metal such as silver (Ag), magnesium (Mg), aluminum (Al), platinum (Pt), palladium (Pd), gold (Au), nickel (Ni), neodymium (Nd), iridium (Ir), chrome (Cr), titanium (Ti), and/or an alloy thereof. However, the material of the alignment electrodes ALE is not limited to the foregoing. The alignment electrodes ALE may include transparent conductive material (or substance). The transparent conductive material (or substance) may include transparent conductive oxides such as indium tin oxide (ITO), indium zinc oxide (IZO), zinc oxide (ZnOₓ), indium gallium zinc oxide (IGZO), and/or indium tin zinc oxide (ITZO), and/or a conductive polymer such as PEDOT (poly(3,4-ethylenedioxythiophene)). In case that the alignment electrodes ALE include a transparent conductive material (or substance), a separate conductive layer formed of opaque metal for reflecting light emitted from the light emitting elements LD in the image display direction of the display device DD may be added. However, the material of the alignment electrodes ALE is not limited to the foregoing materials.

Each of the alignment electrodes ALE may have a single layer structure, but the present disclosure is not limited thereto. Each of the alignment electrodes ALE may be provided and/or formed in a multi-layer structure formed by stacking at least two materials selected from among metals, alloys, conductive oxides, and conductive polymers. Each of the alignment electrodes ALE may be formed of a multi-layer structure including at least two layers to reduce or minimize distortion resulting from a signal delay in case that signals are transmitted to opposite ends of each of the light emitting elements LD, e.g., to the first and second ends EP1 and EP2. For example, each of the alignment electrodes ALE may have a multi-layer structure that selectively further includes at least one selected from among at least one reflective electrode layer, at least one transparent electrode layer disposed over and/or under the reflective electrode layer, and/or at least one conductive capping layer configured to cover an upper portion of the transparent electrode layer.

In the case in which the alignment electrodes ALE are formed of conductive material having a reflectivity, light emitted from the first and second ends EP1 and EP2 of each of the light emitting elements LD may more reliably travel in the image display direction of the display device DD.

The first alignment electrode ALE1 may be electrically connected with the transistor T of the pixel circuit layer PCL through the first contactor CNT1. The second alignment electrode ALE2 may be electrically connected with the second power line PL2 of the pixel circuit layer PCL through the second contactor CNT2.

A first insulating layer INS1 may be disposed on the alignment electrodes ALE.

The first insulating layer INS1 may be disposed on the alignment electrodes ALE and the via layer VIA. The first insulating layer INS1 may be partially open in at least the non-emission area NEA so that components disposed thereunder may be exposed. For example, the first insulating layer INS1 may be partially open to include a first contact hole CH1, which is formed by removing one area of the first insulating layer INS1 in at least the non-emission area NEA, and through which one area of the first alignment electrode ALE1 is exposed, and a second contact hole CH2, which is formed by removing another area of the first insulating layer INS1 in at least the non-emission area NEA, and through which one area of the second alignment electrode ALE2 is exposed.

The first insulating layer INS1 may be formed of an inorganic insulating layer made of inorganic material. For instance, the first insulating layer INS1 may include at least one of silicon nitride (SiNₓ), silicon oxide (SiOₓ), silicon oxynitride (SiOₓN_{y}), or aluminum oxide (AlOₓ). The first insulating layer INS1 formed of an inorganic insulating layer may have a profile (or a surface) corresponding to profiles of components disposed thereunder. In this case, a space SP (e.g., referred also to as "gap" or "void") may be present between each of the light emitting elements LD and the first insulating layer INS1. The first insulating layer INS1 may have a single-layer or multi-layer structure. In the case in which the first insulating layer INS1 is provided in the form of a multi-layer structure, the first insulating layer INS1 may have a distributed Bragg reflector structure formed by alternately stacking first inorganic layers and second inorganic layers that have different refractive indexes.

The first insulating layer INS1 may be disposed over the entirety of the emission area EMA and the non-emission area NEA of each pixel PXL, but the present disclosure is not limited thereto. The first insulating layer INS1 may be disposed in only a specific area of each pixel PXL, e.g., in only the emission area EMA.

The first bank BNK1 may be disposed on the first insulating layer INS1.

The first bank BNK1 may be disposed on the first insulating layer INS1 in at least the non-emission area NEA, but the present disclosure is not limited thereto. The first bank BNK1 may be formed, to enclose the emission area EMA of each pixel PXL, between adjacent pixels PXL so that a pixel defining layer for partitioning (or defining) the emission area EMA of the corresponding pixel PXL may be formed. At the step of supplying the light emitting elements LD to the emission area EMA, the first bank BNK1 may be a dam structure configured to prevent a solution (or ink) mixed with the light emitting elements LD from being drawn into the emission areas EMA of the adjacent pixels PXL or control the amount of solution such that a constant amount of solution is supplied to each emission area EMA.

The first bank BNK1 and the bank pattern BNP may be formed through different processes and provided in different layers, but the present disclosure is not limited thereto. The first bank BNK1 and the bank pattern BNP may be formed through different processes and provided at the same layer, or may be formed through the same process and provided at the same layer.

The light emitting elements LD may be supplied to and aligned in the emission area EMA of the pixel PXL in which the first insulating layer INS1 and the first bank BNK1 are formed. For example, the light emitting elements LD may be supplied (or inputted) to the emission area EMA through an inkjet printing scheme or the like. The light emitting elements LD may be aligned between the alignment electrodes ALE by an electric field formed by a signal (or an alignment signal) applied to each of the alignment electrodes ALE. For example, the light emitting elements LD may be aligned on the first insulating layer INS1 between the first alignment electrode ALE1 and the second alignment electrode ALE2.

A second insulating layer INS2 (or an insulating pattern) may be disposed on each of the light emitting elements LD. The second insulating layer INS2 may be located on the light emitting elements LD to partially cover the outer surface (e.g., the outer peripheral or circumferential surface or the surface) of each of the light emitting elements LD such that the first end EP1 and the second end EP2 of each of the light emitting elements LD are exposed to the outside.

The second insulating layer INS2 may include an inorganic insulating layer including inorganic material, or an organic insulating layer. For example, the second insulating layer INS2 may include an inorganic insulating layer suitable for protecting the active layer 12 of each of the light emitting elements LD from external oxygen, water, etc. The second insulating layer INS2 may have a single-layer or multi-layer structure.

Because the second insulating layer INS2 is formed on the light emitting elements LD that have been completely aligned in the emission area EMA of each pixel PXL, the light emitting elements LD may be prevented from being removed from the aligned positions.

The electrodes PE may be formed on the first and second ends EP1 and EP2 of the light emitting elements LD, which are not covered with the second insulating layer INS2. The electrodes PE may include a first electrode PE1 and a second electrode PE2. For example, the first electrode PE1 may be formed on the first ends EP1 of the light emitting elements LD. The second electrode PE2 may be formed on the second ends EP2 of the light emitting elements LD.

The first electrode PE1 may be disposed over the first alignment electrode ALE1 to overlap the first alignment electrode ALE1. The second electrode PE2 may be disposed over the second alignment electrode ALE2 to overlap the second alignment electrode ALE2.

The first electrode PE1 may be electrically connected to the first alignment electrode ALE1 through the first contact hole CH1 of the first insulating layer INS1. The second electrode PE2 may be electrically connected to the second alignment electrode ALE2 through the second contact hole CH2 of the first insulating layer INS1.

Each of the first and second electrodes PE1 and PE2 may be formed of various transparent conductive materials. For example, each of the first and second electrodes PE1 and PE2 may include at least one of various transparent conductive materials including indium tin oxide (ITO), indium zinc oxide (IZO), indium tin zinc oxide (ITZO), aluminum zinc oxide (AZO), gallium zinc oxide (GZO), zinc tin oxide (ZTO), or gallium tin oxide (GTO), and may be substantially transparent or translucent to provide satisfactory transmittance. Hence, light emitted from the first and second ends EP1 and EP2 of the light emitting elements LD may pass through the first and second electrodes PE1 and PE2 and then may be emitted out of the display device DD (or the display panel DP).

The first electrode PE1 and the second electrode PE2 may be formed at the same layer or different layers. For example, relative positions and/or a formation sequence of the first electrode PE1 and the second electrode PE2 may be changed in various ways.

In FIG. 8, the first electrode PE1 and the second electrode PE2 may be concurrently (e.g., simultaneously) formed, with the second insulating layer INS2 interposed therebetween. For example, the first electrode PE1 may be located adjacent to a first side surface (e.g., a left side surface) of the second insulating layer INS2, and the second electrode PE2 may be located adjacent to a second side surface (e.g., a right side surface) of the second insulating layer INS2. The first electrode PE1 may directly contact the first end EP1 of the light emitting element LD and may be electrically connected to the light emitting element LD. The second electrode PE2 may directly contact the second end EP2 of the light emitting element LD and may be electrically connected to the light emitting element LD. In FIG. 8, in the case where the first and second electrodes PE1 and PE2 that are disposed on the first end EP1 and the second end EP2 of the light emitting element LD are disposed at the same layer and concurrently (e.g., simultaneously) formed, a process of fabricating the pixel PXL (or the display device DD) may be facilitated, and the fabrication efficiency may be enhanced.

In FIGS. 9 and 11, the first electrode PE1 to be disposed adjacent to the first side surface of the second insulating layer INS2 may be first formed. Thereafter, the third insulating layer INS3 may be formed to cover the first electrode PE1. The third insulating layer INS3 may be disposed on the first electrode PE1 and cover the first electrode PE1 (or prevent the first electrode PE1 from being exposed to the outside), thus protecting the first electrode PE1. The third insulating layer INS3 may be formed of an inorganic insulating layer including inorganic material, or an organic insulating layer including organic material. The third insulating layer INS3 may have a single-layer or multi-layer structure. The second electrode PE2 may be formed on the third insulating layer INS3.

In FIGS. 10 and 12, the second electrode PE2 to be disposed adjacent to the second side surface of the second insulating layer INS2 may be first formed. Thereafter, the third insulating layer INS3 may be formed to cover the second electrode PE2. The third insulating layer INS3 may be disposed on the second electrode PE2 and cover the second electrode PE2 (or prevent the second electrode PE2 from being exposed to the outside), thus protecting the second electrode PE2. The first electrode PE1 may be formed on the third insulating layer INS3.

In the case where, as illustrated in FIGS. 9 to 12, the electrodes that are disposed on the first end EP1 and the second end EP2 of each light emitting element LD are disposed in different layers, the electrodes may be reliably separated from each other, so that electrical stability between the first and second ends EP1 and EP2 of the light emitting elements LD may be secured.

At least one overcoat layer (e.g., a layer for planarizing the upper surface of the display element layer DPL) may be further disposed over the first electrode PE1 and the second electrode PE2.

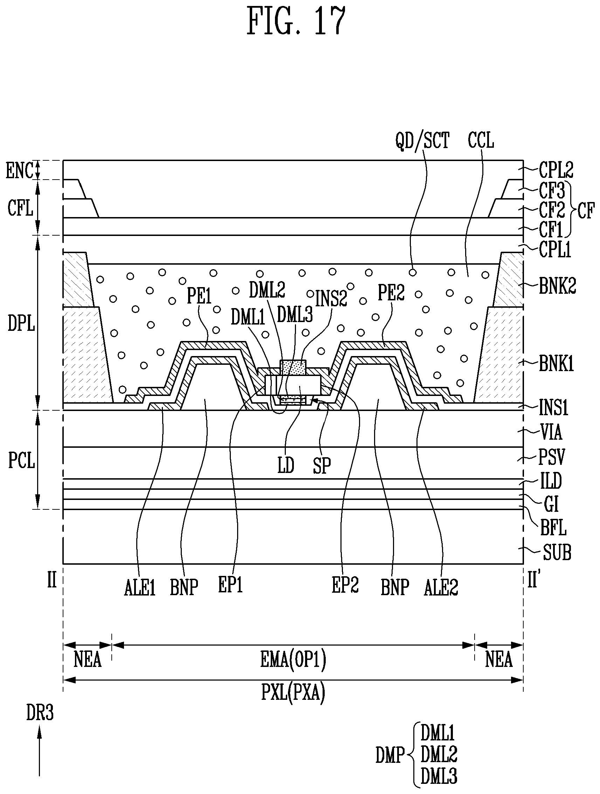

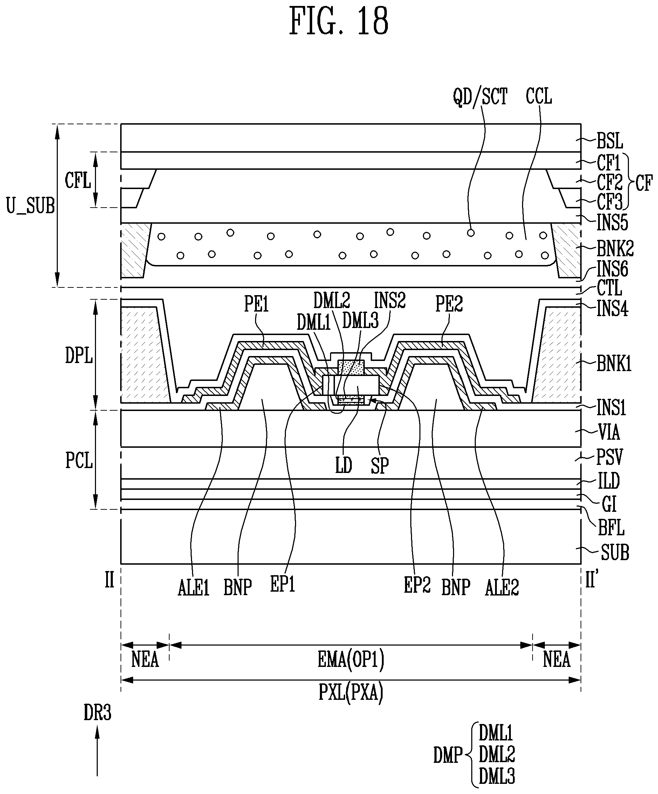

An optical layer may be selectively disposed over the display element layer DPL. For example, the optical layer may include a color conversion layer and a color filter layer that may convert light emitted from the light emitting elements LD to light having excellent color reproducibility and emit the converted light. Detailed descriptions pertaining to the optical layer will be made below with reference to FIGS. 17 and 18.

The pixel PXL may include space SP located between each of the light emitting elements LD and the first insulating layer INS1 disposed therebelow. The space SP may be a void (or a gap) enclosed by each of the light emitting elements LD and the first insulating layer INS1, in a sectional view.

A dummy pattern DMP may be located in the space SP.

The dummy pattern DMP may be a structure that is located in the space SP and interrupts electrical connection of conductive material (e.g., base conductive material of the first and second electrodes PE1 and PE2) formed in the space SP during a process of forming the first electrode PE1 and the second electrode PE2. The dummy pattern DMP may be formed as a separable insulating pattern that is individually disposed under the light emitting elements LD, but the present disclosure is not limited thereto.

The dummy pattern DMP may have a multi-layer structure. For example, the dummy pattern DMP may include a first dummy layer DML1, a second dummy layer DML2, and a third dummy layer DML3 that are successively stacked in the third direction DR3.

The first dummy layer DML1 may be directly disposed on one surface of the first insulating layer INS1 in the space SP and contact the first insulating layer INS1. The third dummy layer DML3 may be directly disposed on one surface (e.g., a rear surface) of the light emitting element LD in the space SP and contact the light emitting element LD. The second dummy layer DML2 may be disposed between the first dummy layer DML1 and the third dummy layer DML3 in the space SP.

Each of the first and third dummy layers DML1 and DML3 may be formed of an inorganic insulating layer including inorganic material. The second dummy layer DML2 may be formed of an organic insulating layer including organic material. The inorganic insulating layer may include, for example, silicon nitride (SiNₓ), silicon oxide (SiOₓ), or silicon oxynitride (SiOₓN_{y}), but the present disclosure is not limited thereto. The organic insulating layer may include, for example, organic insulating material such as polyacrylate resin, epoxy resin, phenolic resin, polyamide resin, polyimide resin, unsaturated polyester resin, polyphenylene resin, polyphenylene sulfide resin, or benzocyclobutene (BCB), but the present disclosure is not limited thereto.

The first dummy layer DML1 and the third dummy layer DML3 may include the same material as the second insulating layer INS2.

The dummy pattern DMP may be located in the space SP and correspond to the second insulating layer INS2. For example, the dummy pattern DMP may oppose the second insulating layer INS2 located on the light emitting elements LD in the third direction DR3, with each light emitting element LD interposed therebetween. The dummy pattern DMP may be located under the light emitting element LD, and the second insulating layer INS2 may be located over the light emitting element LD.

As shown in FIG. 13A, a width d1 of the dummy pattern DMP may be identical or substantially similar to a width d2 of the second insulating layer INS2. The width d1 of the dummy pattern DMP and the width d2 of the second insulating layer INS2 each may be less than the length (refer to "L" of FIG. 1) of the light emitting element LD. For example, the width d1 of the dummy pattern DMP and the width d2 of the second insulating layer INS2 each may be 1.6 µm ± 0.5 µm, but the present disclosure is not limited thereto. The width d1 of the dummy pattern DMP may be greater or less than the width d2 of the second insulating layer INS2.

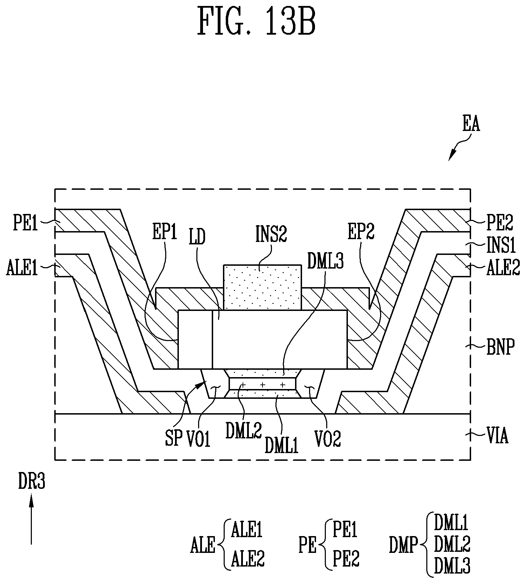

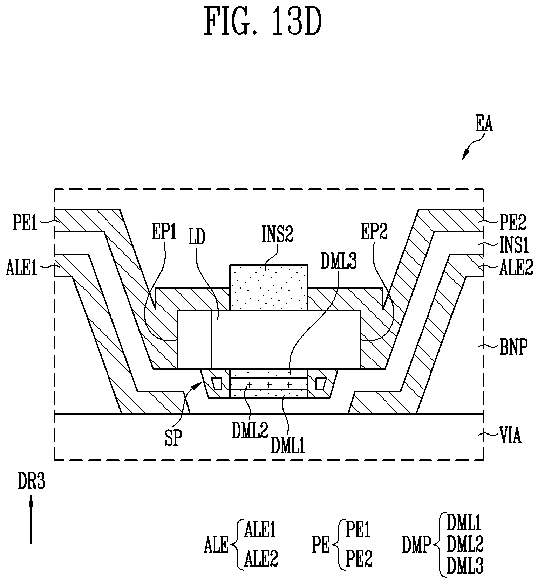

In the case in which the dummy pattern DMP is located in the space SP and corresponds to the second insulating layer INS2, the dummy pattern DMP may overlap neither the first end EP1 of the light emitting element LD nor the second end EP2 of the light emitting element LD, and may overlap the other area of the light emitting element LD except the first and the second ends EP1 and EP2. For example, as illustrated in FIGS. 13A, 13B, and 13D, the dummy pattern DMP may be located in the space SP at a position corresponding to an intermediate point of the light emitting element LD based on the length L of the light emitting element LD. In the case where the dummy pattern DMP is located in the space SP, the space SP may include a first void VO1 and a second void VO2 with the dummy pattern DMP interposed therebetween. The first void VO1 may be located to correspond to the first end EP1 of the light emitting element LD. The second void VO2 may be located to correspond to the second end EP2 of the light emitting element LD.

Taking into account a contact margin or the like between the light emitting element LD and the first and second electrodes PE1 and PE2 disposed thereon, the dummy pattern DMP may be disposed to be biased to one side in the space SP only in the case where the first electrode PE1 and the second electrode PE2 are formed in different layers through different processes. For example, the dummy pattern DMP may be located to be biased to one side to correspond to one end of the first and second ends EP1 and EP2 of the light emitting element LD in the space SP enclosed by the light emitting element LD and the first insulating layer INS1, as illustrated in FIGS. 11 and 12.

In FIG. 11, the dummy pattern DMP may be disposed to be biased to one side in the space SP to correspond to the first end EP1 of the light emitting element LD that contacts the first electrode PE1. In this case, the space SP may include a void VO corresponding to the second end EP2 of the light emitting element LD. The third insulating layer INS3 may be formed on the first electrode PE1. The second electrode PE2 may be formed on the third insulating layer INS3.

In FIG. 12, the dummy pattern DMP may be disposed to be biased to one side in the space SP to correspond to the second end EP2 of the light emitting element LD that contacts the second electrode PE2. In this case, the space SP may include a void VO corresponding to the first end EP1 of the light emitting element LD. The third insulating layer INS3 may be formed on the second electrode PE2. The first electrode PE1 may be formed on the third insulating layer INS3.

The dummy pattern DMP may have a rectangular shape in a sectional view, but the present disclosure is not limited thereto. The dummy pattern DMP may have a polygonal shape in which the dummy layers have different inclinations on side surfaces thereof. For example, as illustrated in FIG. 13B, the dummy pattern DMP may have a polygonal shape, including a third dummy layer DML3 having an inverted tapered shape, a first dummy layer DML1 having a forward tapered shape, and a second dummy layer DML2 having side surfaces located more inside than respective side surfaces of the first and second dummy layers DML1 and DML3.

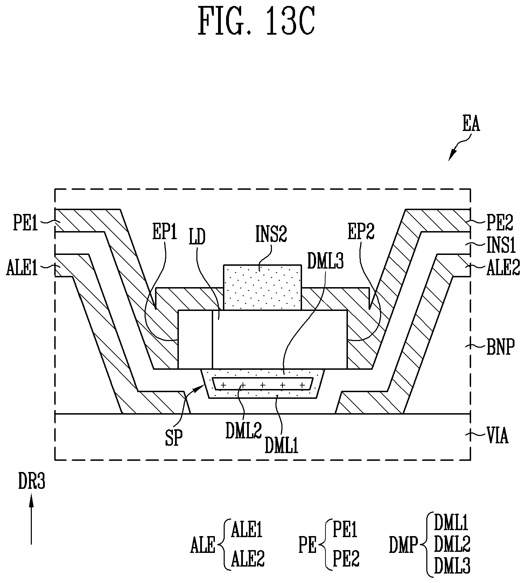

As illustrated in FIG. 13C, the entirety of the space SP may be filled with the dummy pattern DMP. In this case, the first dummy layer DML1 and the third dummy layer DML3 may be connected to each other on side surfaces of the first insulating layer INS1 in the space SP.

As illustrated in FIG. 13D, in accordance with the present invention, the first electrode PE1 and the second electrode PE2 are formed in the space SP at a fabrication step thereof. Each of the first electrode PE1 and the second electrode PE2 that are formed in the space SP may enclose the first insulating layer INS1, the light emitting element LD, and the dummy pattern DMP in the space SP. For example, the first electrode PE1 may be around the rear surface of the light emitting element LD, the first insulating layer INS1, and a first side surface (e.g., a left side surface) of the dummy pattern DMP in the space SP. The second electrode PE2 may be around the rear surface of the light emitting element LD, the first insulating layer INS1, and a second side surface (e.g., a right side surface) of the dummy pattern DMP in the space SP. In accordance with the present invention, the first electrode PE1 and the second electrode PE2 are spaced from each other with the dummy pattern DMP interposed therebetween in the space SP. In other words, the first electrode PE1 and the second electrode PE2 are electrically and physically separated from each other by the dummy pattern DMP in the space SP.

The first electrode PE1 and the second electrode PE2 may be electrically and physically separated from each other by the dummy pattern DMP in the space SP located under the light emitting element LD, and may be electrically and physically separated from each other by the second insulating layer INS2 located over the light emitting element LD.

In accordance with the foregoing, the dummy pattern DMP may be disposed in the space SP enclosed by the light emitting element LD and the first insulating layer INS1 so that, even if the first electrode PE1 and the second electrode PE2 are formed in the space SP, the first electrode PE1 and the second electrode PE2 may be completely electrically and physically separated from each other by the dummy pattern DMP, whereby probability of occurrence of a defect attributable to a short-circuit between the first electrode PE1 and the second electrode PE2 may be reduced or minimized. Hence, the reliability of the pixel PXL and the display device DD including the pixel PXL may be enhanced.

In accordance with the foregoing, in the case where the first electrode PE1 and the second electrode PE2 are formed in the space SP, a contact surface area between the light emitting element LD and each of the first and second electrodes PE1 and PE2 may be increased, so that contact failure between the light emitting element LD and the corresponding electrode may be reduced or minimized.

In accordance with the foregoing, in the case where the dummy pattern DMP is provided in such a way that the entirety of the space SP enclosed by the light emitting element LD and the first insulating layer INS1 is filled with the dummy pattern DMP, the dummy pattern DMP with which the space SP is filled may stably support the rear surface (or the lower surface) of the light emitting element LD.

In accordance with the foregoing, the dummy pattern DMP is located on the rear surface of the light emitting element LD, and the second insulating layer INS2 is located on the upper surface of the light emitting element LD, so that the light emitting element LD may be more reliably fixed, whereby removal of the light emitting element LD from the aligned position may be reduced or minimized.

FIGS. 17 and 18 illustrate a pixel PXL, and are schematic cross-sectional views corresponding to the line II-II' of FIG. 6.

FIGS. 17 to 18 illustrate different modification examples with regard to the position of a color conversion layer CCL. For example, FIG. 17 illustrates an implementation in which the color conversion layer CCL and a color filter layer CFL are disposed over the first and second electrodes PE1 and PE2 through successive processes. FIG. 18 illustrates an implementation in which an upper substrate U_SUB including the color conversion layer CCL and the color filter layer CFL is disposed on the display element layer DPL through an adhesive process using an intermediate layer CTL.

The description of FIGS. 17 and 18 will be focused on differences from the above-mentioned implementations so as to avoid redundant description.

Referring to FIGS. 1 to 17, each pixel PXL may include a substrate SUB, a pixel circuit layer PCL, a display element layer DPL, a color filter layer CFL, and an encapsulation layer ENC.

The display element layer DPL may include a bank pattern BNP, first and second alignment electrodes ALE1 and ALE2, a first bank BNK1, a light emitting element LD, and first and second electrodes PE1 and PE2. The display element layer DPL may further include a second bank BNK2 disposed on the first bank BNK1, the color conversion layer CCL disposed on the first and second electrodes PE1 and PE2, and a first capping layer CPL1 disposed on the color conversion layer CCL and the second bank BNK2.

The second bank BNK2 may be disposed on the first bank BNK1 in the non-emission area NEA of the pixel PXL. The second bank BNK2 may be a dam structure that encloses the emission area EMA of the pixel PXL and defines a position at which the color conversion layer CCL is to be supplied, thus eventually defining the emission area EMA.

The second bank BNK2 may include light blocking material. For example, the second bank BNK2 may be a black matrix, but the present disclosure is not limited thereto. The second bank BNK2 may include at least one light blocking material and/or reflective material, and allow light emitted from the color conversion layer CCL to more reliably travel in the image display direction of the display device DD, thus enhancing the light output efficiency of the color conversion layer CCL.

The color conversion layer CCL may include color conversion particles QD corresponding to a specific color. For example, the color conversion layer CCL may include color conversion particles QD that convert a first color of light emitted from the light emitting element LD to a second color of light (a specific color of light, or light having excellent color reproducibility).

In the case in which the pixel PXL is a red pixel (or a red sub-pixel), the color conversion layer CCL of the pixel PXL may include color conversion particles QD formed of red quantum dots that convert a first color of light emitted from the light emitting element LD to a second color of light (e.g., red light).

In the case in which the pixel PXL is a green pixel (or a green sub-pixel), the color conversion layer CCL of the pixel PXL may include color conversion particles QD formed of green quantum dots that convert a first color of light emitted from the light emitting element LD to a second color of light (e.g., green light).

In the case in which the pixel PXL is a blue pixel (or a blue sub-pixel), the color conversion layer CCL of the pixel PXL may include color conversion particles QD formed of blue quantum dots that convert a first color of light emitted from the light emitting element LD to a second color of light (e.g., blue light). In the case in which the pixel PXL is a blue pixel (or a blue sub-pixel), there may be provided a light scattering layer having light scattering particles SCT, in place of the color conversion layer CCL having the color conversion particles QD. For example, in case that the light emitting element LD emits blue-based light, the pixel PXL may include a light scattering layer including light scattering particles SCT. The light scattering layer may be omitted. In the case in which the pixel PXL is a blue pixel (or a blue sub-pixel), there may be provided a transparent polymer, in place of the color conversion layer CCL.

The first capping layer CPL1 may be disposed on the color conversion layer CCL and the second bank BNK2.

The first capping layer CPL1 may be provided on the overall surface of the display area DA, in which the pixel PXL is disposed, to cover the second bank BNK2 and the color conversion layer CCL.

The first capping layer CPL may be an inorganic insulating layer including inorganic material. The first capping layer CPL may include at least one of silicon nitride (SiNₓ), silicon oxide (SiOₓ), silicon oxynitride (SiOₓN_{y}), or aluminum oxide (AlOₓ), and the like. The first capping layer CPL may cover the entireties of the second bank BNK2 and the color conversion layer CCL and thus prevent external water, oxygen, or the like from being drawn into the color conversion layer CCL.

The first capping layer CPL1 may mitigate a step difference formed by components disposed thereunder and have a planar surface. For example, the first capping layer CPL1 may include an organic insulating layer including organic material, but the present disclosure is not limited thereto. The first capping layer CPL1 may be a common layer provided in common in the display area DA.

The color filter layer CFL may be disposed on the first capping layer CPL.

The color filter layer CFL may include a color filter CF corresponding to the emission area EMA of each pixel PXL. For example, the color filter layer CFL may include a first color filter CF1 disposed on the color conversion layer CCL of one pixel PXL (hereinafter, referred to as "first pixel"), a second color filter CF2 disposed on the color conversion layer of an adjacent pixel (hereinafter, referred to as "second pixel") adjacent to the first pixel PXL, and a third color filter CF3 disposed on the color conversion layer of an adjacent pixel (hereinafter, referred to as "third pixel") adjacent to the second pixel.

The first, second, and third color filters CF1, CF2, and CF3 may be disposed in the non-emission area NEA and overlap each other, thus functioning as a light blocking component for preventing optical interference between adjacent pixels PXL from occurring. The first, second, and third color filters CF1, CF2, and CF3 each may include color filter material that allows the second color of light converted by the corresponding color conversion layer CCL to selectively pass therethrough. For example, the first color filter CF1 may be a red color filter, the second color filter CF2 may be a green color filter, and the third color filter CF3 may be a blue color filter, but the present disclosure is not limited thereto.

The encapsulation layer ENC may be disposed on the color filter layer CFL.

The encapsulation layer ENC may include a second capping layer CPL2. The second capping layer CPL2 may be an inorganic insulating layer including inorganic material or an organic insulating layer including organic material. The second capping layer CPL2 may cover the entireties of components disposed thereunder and prevent external water, moisture, or the like from being drawn into the color filter layer CFL and/or the display element layer DPL. The encapsulation layer ENC may be used as a planarization layer for mitigating a step difference caused by the components of the color filter layer CFL and/or the display element layer DPL that are located under the encapsulation layer ENC.

The second capping layer CPL2 may have a multi-layer structure. For example, the second capping layer CPL2 may be formed of at least two inorganic insulating layers, and at least one organic insulating layer interposed between the at least two inorganic insulating layers. Here, the constituent material and/or structure of the second capping layer CPL2 may be changed in various ways. At least one overcoat layer, at least one filler layer, and/or at least another substrate may be further disposed over the second capping layer CPL2.

In the pixel PXL in accordance with the foregoing implementation, the color conversion layer CCL and the color filter layer CFL may be disposed on the light emitting elements LD through successive processes so that light having excellent light reproducibility may be emitted through the color conversion layer CCL and the color filter layer CFL, whereby the light output efficiency may be enhanced.

As illustrated in FIG. 18, the color conversion layer CCL and the color filter layer CFL may be formed on one surface of a base layer BSL through successive processes, thus forming a separate substrate, e.g., an upper substrate U_SUB. The upper substrate U_SUB may be coupled to the display element layer DPL including the first and second electrodes PE1 and PE2 and the like, through the intermediate layer CTL. Here, a fourth insulating layer INS4 may be disposed on the first and second electrodes PE1 and PE2. The fourth insulating layer INS4 may cover the first and second electrodes PE1 and PE2 through a process of coupling the display element layer DPL to the upper substrate U_SUB, thus preventing the first and second electrodes PE1 and PE2 from being exposed to the outside. The fourth insulating layer INS4 may be an inorganic insulating layer including inorganic material, but the present disclosure is not limited thereto.

The intermediate layer CTL may be a transparent adhesive layer (or a transparent bonding layer), e.g., an optically clear adhesive layer, for enhancing the adhesive force between the display element layer DPL and the upper substrate U_SUB, but the present disclosure is not limited thereto. The intermediate layer CTL may be a refractive index conversion layer configured to change the refractive index of light emitted from the light emitting elements LD toward the upper substrate U_SUB and enhance emission luminance of the pixel PXL. The intermediate layer CTL may include a filler formed of insulating material having insulation property and adhesion property.

The upper substrate U_SUB may include a base layer BSL, a color filter layer CFL, a fifth insulating layer INS5, a second bank BNK2, a color conversion layer CCL, and a sixth insulating layer INS6.

The base layer BSL may be a rigid or flexible substrate, and the material or properties thereof are not particularly limited. The base layer BSL may be formed of the same material as that of the substrate SUB, or may be formed of material different from that of the substrate SUB.

The color filter layer CFL may be disposed on one surface of the base layer BSL and oppose the display element layer DPL. The first color filter CF1 of the color filter layer CFL may be provided on one surface of the base layer BSL to correspond to the color conversion layer CCL in the emission area EMA. The first, second, and third color filters CF1, CF2, and CF3 of the color filter layer CFL may be disposed in the non-emission area NEA and overlap each other, thus functioning as a light blocking component.

The fifth insulating layer INS5 may be disposed between the color filter layer CFL and the color conversion layer CCL.

The fifth insulating layer INS5 may be disposed on the color filter layer CFL and cover the color filter layer CFL, thus protecting the color filter layer CFL. The fifth insulating layer INS5 may be an inorganic insulating layer including inorganic material or an organic insulating layer including organic material.

The second bank BNK2 and the color conversion layer CCL may be disposed on one surface of the fifth insulating layer INS5.

The sixth insulating layer INS6 may be disposed on the overall surfaces of the second bank BNK2 and the color conversion layer CCL.

For example, the sixth insulating layer INS6 may include at least one of silicon nitride (SiNₓ), silicon oxide (SiOₓ), silicon oxynitride (SiOₓN_{y}), or a metal oxide such as aluminum oxide (AlOₓ), but the present disclosure is not limited thereto. The sixth insulating layer INS6 may be formed of an organic layer including organic material. The sixth insulating layer INS6 may be disposed on the color conversion layer CCL and protect the color conversion layer CCL from external water or moisture so that the reliability of the color conversion layer CCL may be further enhanced.

The upper substrate U_SUB may be connected with the display element layer DPL by the intermediate layer CTL.

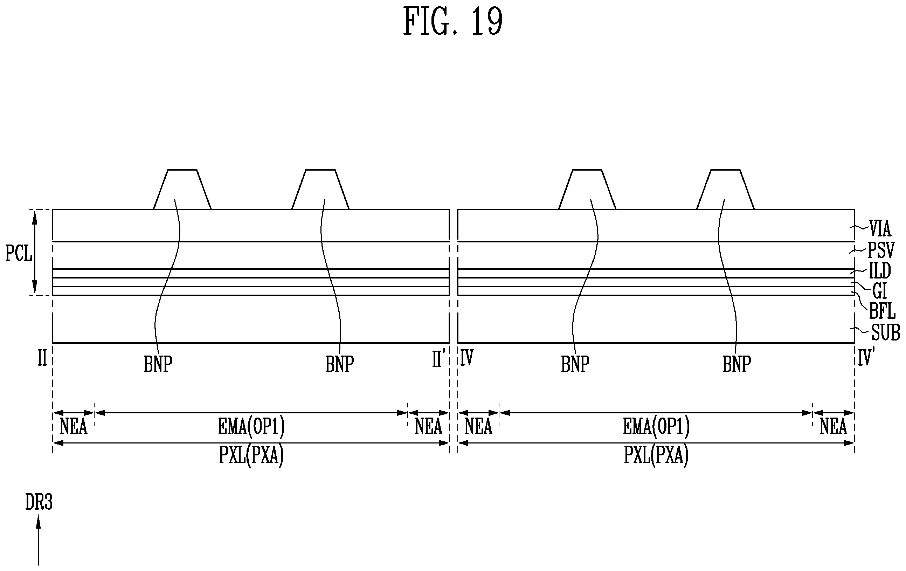

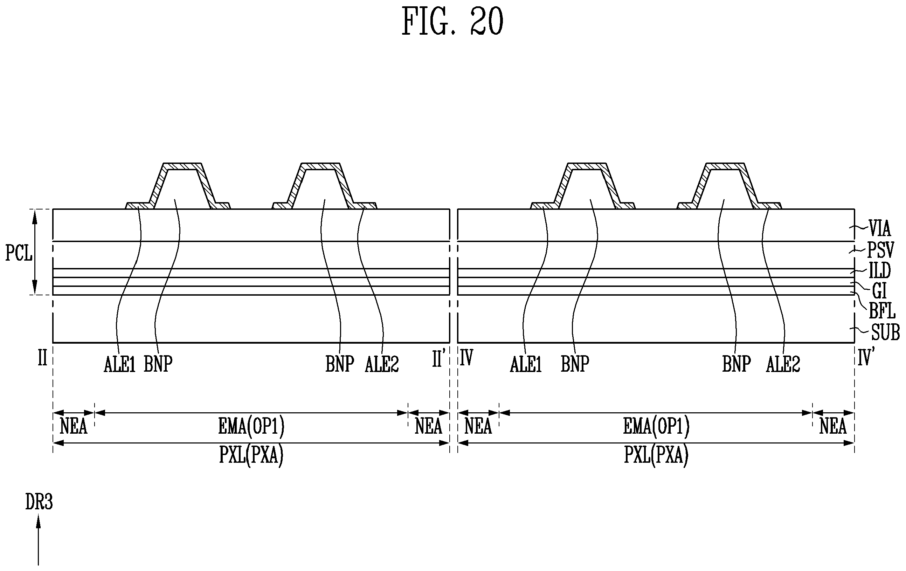

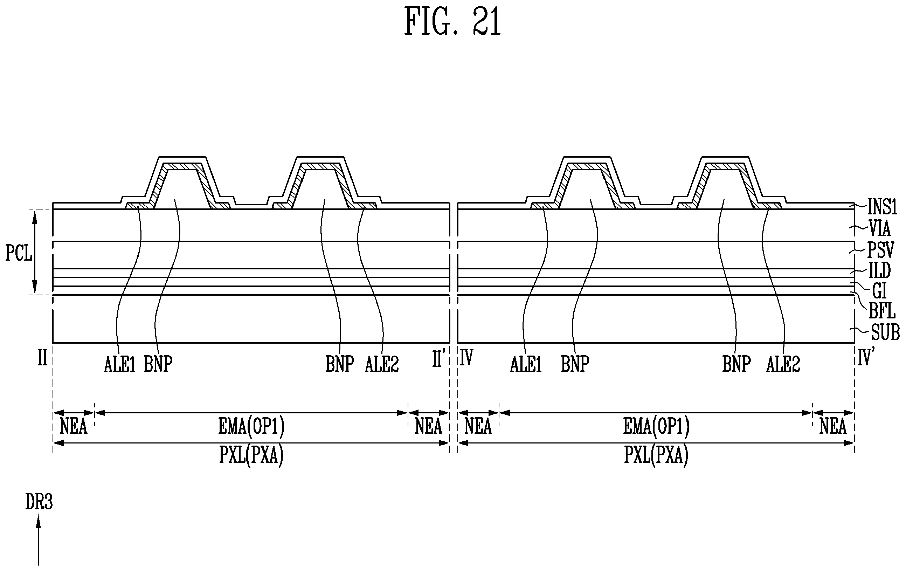

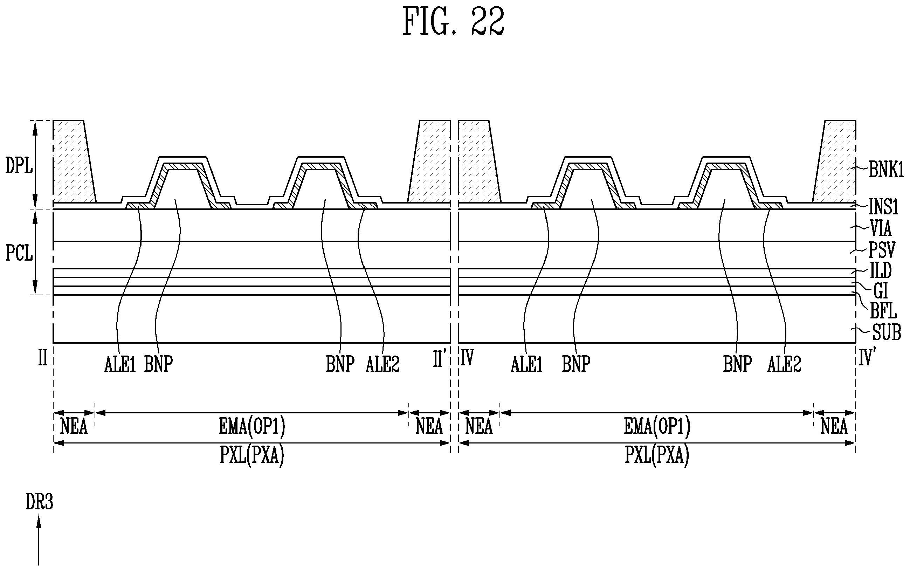

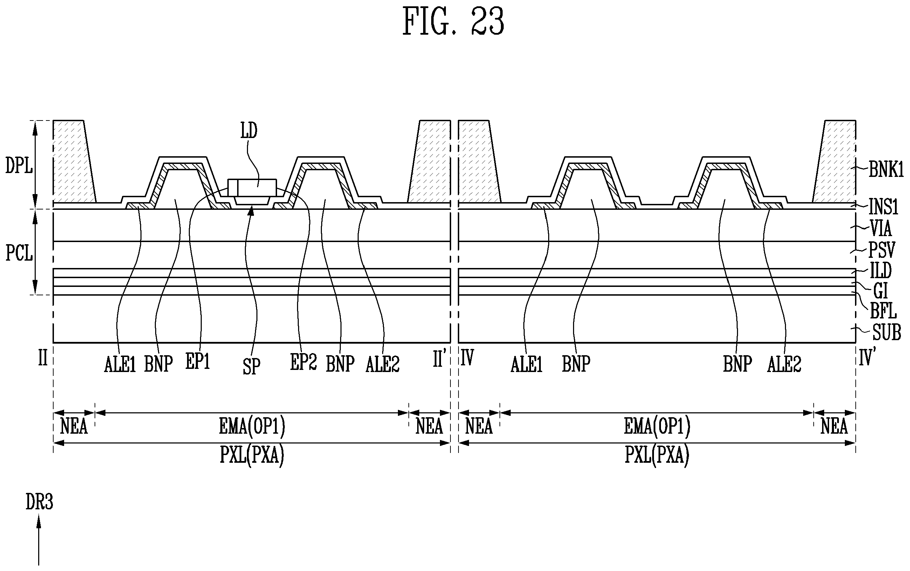

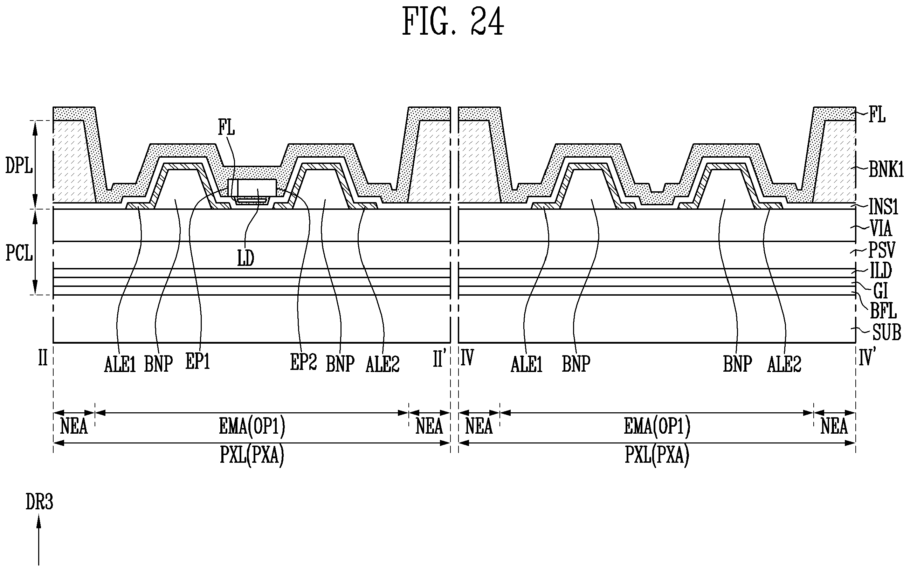

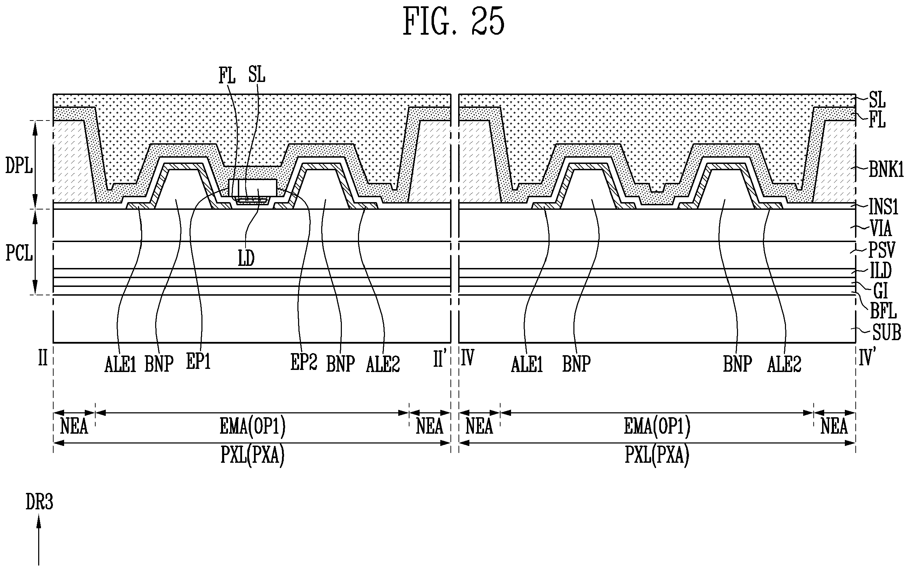

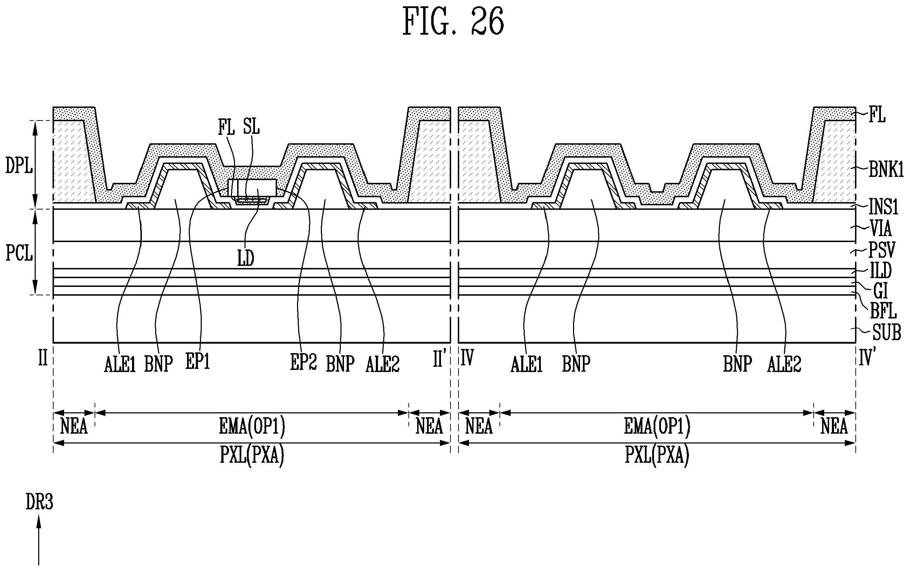

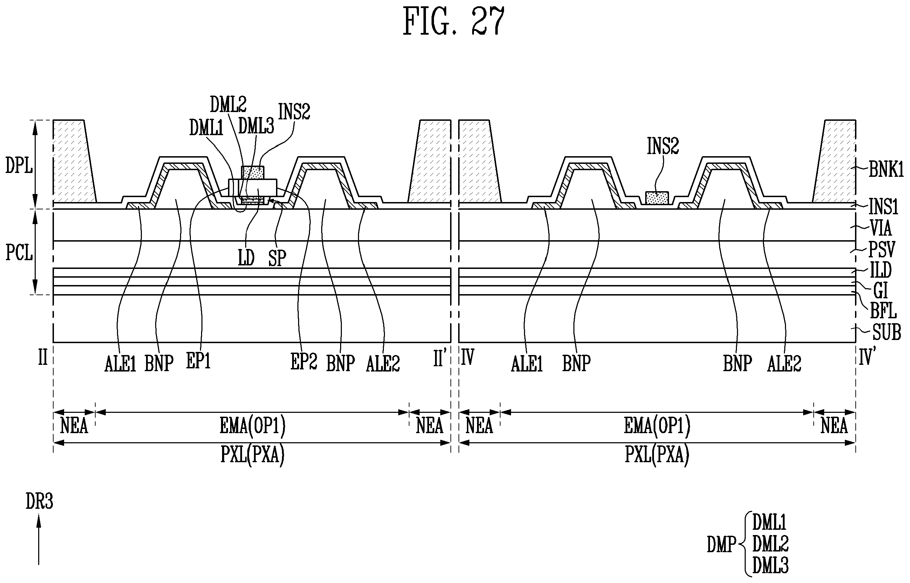

FIGS. 19 to 27 are views for describing a method of fabricating a display device, and are schematic cross-sectional views corresponding to the line II-II' and line IV - IV' of FIG. 6.

Hereinafter, a method of fabricating the display device will be sequentially described with reference to FIGS. 19 to 27.

There is illustrated the case where the steps of fabricating the display device are sequentially performed according to the sectional views, but without changing the technical scope of the present disclosure, some steps illustrated as being successively performed may be concurrently (e.g., simultaneously) performed, the sequence of the steps may be changed, some steps may be skipped, or an additional step may be further included between the steps.

The description with reference to FIGS. 19 to 27 will be focused on differences from the above-mentioned implementations so as to avoid redundant description.

Referring to FIGS. 1 to 19, the pixel circuit layer PCL is formed on the substrate SUB of the pixel area PXA. The bank patterns BNP are formed on the pixel circuit layer PCL.

A plurality of insulating layers and circuit elements may be disposed in the pixel circuit layer PCL.

Referring to FIGS. 1 to 20, the first alignment electrode ALE1 and the second alignment electrode ALE2 are formed on the corresponding bank patterns BNP. The first alignment electrode ALE1 and the second alignment electrode ALE2 may be spaced from each other.

The first and second alignment electrodes ALE1 and ALE2 may be formed of opaque metal including metal such as silver (Ag), magnesium (Mg), aluminum (Al), platinum (Pt), palladium (Pd), gold (Au), nickel (Ni), neodymium (Nd), iridium (Ir), chrome (Cr), titanium (Ti), and/or an alloy thereof. For example, the first and second alignment electrodes ALE1 and ALE2 may be formed of opaque metal including aluminum (Al).

Referring to FIGS. 1 to 21, the first insulating layer INS1 is formed on the first and second alignment electrodes ALE1 and ALE2 and the via layer VIA of the pixel circuit layer PCL. The first insulating layer INS1 may be an inorganic insulating layer including inorganic material. The first insulating layer INS1 may have a profile corresponding to the profiles of the first and second alignment electrodes ALE1 and ALE2 and thus include a stepped portion formed between the first alignment electrode ALE1 and the second alignment electrode ALE2.

Referring to FIGS. 1 to 22, the first bank BNK1 is formed on the first insulating layer INS1. The first bank BNK1 may define the respective emission areas EMA of the pixel PXL and pixels PXL adjacent thereto. The first bank BNK1 may define each emission area EMA to which the light emitting elements LD are to be supplied in case that the light emitting elements LD are supplied to the corresponding pixel PXL.

Referring to FIGS. 1 to 23, the first alignment electrode ALE1 and the second alignment electrode ALE2 are respectively supplied with corresponding alignment signals so that an electric field may be formed between the first alignment electrode ALE1 and the second alignment electrode ALE2.

Ink including light emitting elements LD is inputted to the pixel area PXA through an inkjet printing scheme or the like. For example, at least one inkjet nozzle may be disposed on the first insulating layer INS1, and ink mixed with a plurality of light emitting elements LD may be inputted to the pixel area PXA through the inkjet nozzle. Self-alignment of the light emitting elements LD may be induced on the first insulating layer INS1 between the first alignment electrode ALE1 and the second alignment electrode ALE2.

After the light emitting elements LD are self-aligned, a solvent included in the ink may be removed by a volatilization scheme or other schemes.

Due to the stepped portion of the first insulating layer INS1 that is located between the first alignment electrode ALE1 and the second alignment electrode ALE2, space SP may be formed between the light emitting element LD and the first insulating layer INS1 located under the light emitting element LD. The space SP may be a void enclosed by the light emitting element LD and the first insulating layer INS1.

Referring to FIGS. 1 to 24, a first layer FL is formed on the entireties of the light emitting elements LD, the first insulating layer INS1, and the first bank BNK1 through a chemical vapor deposition (CVD) method or the like.

The first layer FL may be an inorganic insulating layer including inorganic material. For example, the first layer FL may include at least one of silicon nitride (SiNₓ), silicon oxide (SiOₓ), silicon oxynitride (SiOₓN_{y}), or aluminum oxide (AlOₓ).

At the foregoing deposition step, the first layer FL may be drawn into the space SP and formed on each of the rear surface (or the lower surface) of the light emitting element LD and upper surface and side surfaces of the first insulating layer INS1. The first layers FL formed in the space SP may be connected to each other and may be successive to each other.

Referring to FIGS. 1 to 25, a second layer SL is formed on the overall surface of the first layer FL through a spin coating scheme or the like.

The second layer FL may be an organic insulating layer including organic material. For example, the second layer SL may include at least one of polyacrylates resin, epoxy resin, phenolic resin, polyamides resin, polyimides rein, unsaturated polyesters resin, poly-phenylen ethers resin, poly-phenylene sulfides resin, or benzocyclobutene resin.

At the foregoing coating step, the second layer SL is drawn into the space SP and charged into a remaining portion of the space SP except the first layer FL.

Referring to FIGS. 1 to 26, the first layer FL is exposed to the outside by removing the second layer SL through a dry etching scheme.

At the foregoing dry etching step, the first and second layers FL and SL formed in the space SP may not be etched by the light emitting element LD that is located thereover.

Referring to FIGS. 1 to 27, a photolithography process using a mask is performed so that the second insulating layer INS2 may be formed by removing a portion of the first layer FL that is exposed to the outside.

The second insulating layer INS2 may be located on the upper surface of the light emitting element LD such that the first and second ends EP1 and EP2 of the light emitting element LD are exposed from the second insulating layer INS2. Furthermore, the second insulating layer INS2 may be located on the first insulating layer INS1 between the first alignment electrode ALE1 and the second alignment electrode ALE2 in a portion of the emission area EMA where the light emitting element LD is not disposed.

The dummy pattern DMP may be formed by removing, using etching gas that is used through the foregoing process, respective portions of the first layer FL and the second layer SL that are located in the space SP. For example, the first dummy layer DML1 may be formed by removing, from the space SP, a portion of the first layer FL that is located on the side surface of the first insulating layer INS1 and removing, from the space SP, a portion of the first layer FL that is located on the upper surface of the first insulating layer INS1. Furthermore, the third dummy layer DML3 is formed by removing, from the space SP, a portion of the first layer FL that is located on the rear surface of the light emitting element LD. The second dummy layer DML2 is formed by removing a portion of the second layer SL from the space SP.

The dummy pattern DMP including the first dummy layer DML1, the second dummy layer DML2, and the third dummy layer DML3 that are successively stacked in the third direction DR3 may be ultimately formed in the space SP.

The first dummy layer DML1, the third dummy layer DML3, and the second insulating layer INS2 each may be formed of an inorganic insulating layer. The second dummy layer DML2 may be formed of an organic insulating layer.

In accordance with the present invention, after the dummy pattern DMP and the second insulating layer INS2 are formed, a process of applying base conductive material and forming the first electrode PE1 and the second electrode PE2 is performed. During the foregoing process, the base conductive material is drawn into the space SP through the opposite sides of the space SP. Because the dummy pattern DMP that contacts the rear surface of the light emitting element LD and the upper surface of the first insulating layer INS1 is located in the space SP, the base conductive material that is located on one side of the dummy pattern DMP in the space SP and the base conductive material that is located on another side of the dummy pattern DMP is prevented from being connected to each other and short-circuiting with each other.

In the display device DD (or the pixel PXL) formed through the foregoing fabrication method, the dummy pattern DMP including insulating material is disposed in the space SP formed between the first insulating layer INS1 and the light emitting element LD, so that a short-circuit defect caused by connection between the first electrode PE1 and the second electrode PE2 in the space SP may be reduced or minimized, whereby the reliability may be enhanced.

While various embodiments have been described above, those skilled in the art will appreciate that various modifications, additions and substitutions are possible, without departing from the scope of the present invention as defined by the claims.

Therefore, the embodiments disclosed in this specification are only for illustrative purposes rather than limiting the technical scope of the present invention as defined by the accompanying claims.

## Claims

1. A display device comprising a plurality of pixels on a substrate (SUB), wherein each of the plurality of pixels comprises:
a first alignment electrode (ALE1) and a second alignment electrode (ALE2) located on the substrate (SUB) and spaced from each other;
a first insulating layer (INS1) on the first alignment electrode (ALE1) and the second alignment electrode (ALE2);
a light emitting element (LD) located on the first insulating layer (INS1) between the first alignment electrode (ALE1) and the second alignment electrode (ALE2);
a dummy pattern (DMP) located on each of a rear surface of the light emitting element (LD) and an upper surface of the first insulating layer (INS1) in a space (SP) enclosed by the first insulating layer (INS1) and the light emitting element (LD);
a second insulating layer (INS2) located on the light emitting element (LD) and exposing a first end (EP1) and a second end (EP2) of the light emitting element (LD);
a first electrode (PE1) electrically connected to the first end (EP1) of the light emitting element (LD); and
a second electrode (PE2) spaced from the first electrode (PE1), and electrically connected to the second end (EP2) of the light emitting element (LD),
wherein the dummy pattern (DMP) comprises the same material as the second insulating layer (INS2);
wherein the first electrode (PE1) and the second electrode (PE2) are formed in the space (SP) and are spaced from each other within the space (SP) with the dummy pattern (DMP) interposed therebetween.

2. The display device according to claim 1, wherein the dummy pattern and the second insulating layer have the same width.

3. The display device according to claim 1 or 2, wherein the dummy pattern comprises a first dummy layer (DML1), a second dummy layer (DML2) and a third dummy layer (DML3) that are successively stacked in the space (SP).

4. The display device according to claim 3,
wherein the first dummy layer (DML1) is located on the first insulating layer (INS1) and contacts the first insulating layer,
wherein the third dummy layer (DML3) is located on the rear surface of the light emitting element (LD) and contacts the rear surface of the light emitting element, and
wherein the second dummy layer (DML2) is located between the first dummy layer and the third dummy layer.

5. The display device according to claim **4,** wherein each of the first dummy layer (DML1) and the third dummy layer (DML3) comprise the same material as the second insulating layer (INS2), and the second dummy layer (DML) comprises a different material from the second insulating layer (INS2), optionally wherein each of the first dummy layer, the third dummy layer, and the second insulating layer comprise an inorganic insulating layer, and the second dummy layer comprises an organic insulating material.

6. The display device according to any one of claims 1 to 5, wherein the dummy pattern is located to correspond to the second insulating layer in the space.

7. The display device according to claim 1, wherein, in a cross-sectional view, the dummy pattern has a polygonal shape including side surfaces having different inclinations.

8. The display device according to any one of claims 1 to 4,
wherein each of the plurality of pixels comprises a third insulating layer (INS3) on the second insulating layer,
wherein the third insulating layer (INS3) covers one of the first and the second electrodes (PE1, PE2), and
wherein the other one of the first and the second electrodes is located on the third insulating layer.

9. The display device according to claim 8, wherein the dummy pattern is located adjacent to one of the first and the second alignment electrodes in the space.

10. The display device according to any one of claims 2 to 9, wherein the first electrode (PE1) and the second electrode (PE2) are spaced from each other with the second insulating layer (INS2) interposed therebetween.

11. The display device according to any one of the preceding claims, wherein each of the plurality of pixels comprises:
an emission area and a non-emission area;
a first bank located in the non-emission area, and including an opening corresponding to the emission area;
the light emitting element located in the emission area;
a color conversion layer over the first and the second electrodes and located in the emission area to correspond to the light emitting element, the color conversion layer comprising color conversion particles;
a second bank on the first bank in the non-emission area, and configured to enclose the color conversion layer; and
a color filter layer located on the color conversion layer and configured to allow light emitted from the color conversion layer to selectively pass therethrough.

12. A method of fabricating a display device, comprising:
forming, on a substrate (SUB), a first alignment electrode (ALE1) and a second alignment electrod (ALE2) spaced from each other;
forming a first insulating layer (INS1) on the first alignment electrode (ALE1) and the second alignment electrode (ALE2);
aligning a light emitting element (LD) on the first insulating layer (INS1) between the first alignment electrode (ALE1) and the second alignment electrode (ALE2);
forming a first layer (FL) on the light emitting element (LD) and the first insulating layer, player (INS1), the first layer (FL) being located on each of a rear surface of the light emitting element (LD) and an upper surface of the first insulating layer (INS1) in a space (SP) enclosed by the light emitting element (LD) and the first insulating layer (INS1);
forming a second layer (SL) on the first layer (FL), the second layer (SL) being between the first laye (FL) located on the rear surface of the light emitting element (LD) and the first layer (FL) located on the upper surface of the first insulating layer (INS1) in the space (SP);
removing, through a dry etching process, the second layer (SL) that is located on the first layer (FL) on the light emitting element (LD);
forming a second insulating layer (INS2) on an upper surface of the light emitting element (LD) by removing a portion of the first layer (FL) through a photolithography process, wherein forming the second insulating layer (INS2) comprises forming a dummy pattern (DMP) by removing respective portions of the first and the second layers (FL, SL) located in the space (SP); and
applying a base conductive material to form a first electrode (PE1) and a second electrode (PE2), wherein the base conductive material is drawn into the space (SP) through the opposite sides of the space (SP) with the dummy pattern (DMP) interposed therebetween.

## Patentansprüche

1. Anzeigevorrichtung, umfassend eine Vielzahl von Pixeln auf einem Substrat (SUB), wobei jedes der Vielzahl von Pixeln Folgendes umfasst:
eine erste Ausrichtungselektrode (ALE1) und eine zweite Ausrichtungselektrode (ALE2), die sich auf dem Substrat (SUB) befinden und voneinander beabstandet sind;
eine erste Isolierschicht (INS1) auf der ersten Ausrichtungselektrode (ALE1) und der zweiten Ausrichtungselektrode (ALE2);
ein lichtemittierendes Element (LD), das sich auf der ersten Isolierschicht (INS1) zwischen der ersten Ausrichtungselektrode (ALE1) und der zweiten Ausrichtungselektrode (ALE2) befindet;
ein Blindmuster (DMP), das sich auf jedem von einer hinteren Fläche des lichtemittierenden Elements (LD) und einer oberen Fläche der ersten Isolierschicht (INS1) in einem Raum (SP) befindet, der durch die erste Isolierschicht (INS1) und das lichtemittierende Element (LD) eingeschlossen ist;
eine zweite Isolierschicht (INS2), die sich auf dem lichtemittierenden Element (LD) befindet und ein erstes Ende (EP1) und ein zweites Ende (EP2) des lichtemittierenden Elements (LD) freilegt;
eine erste Elektrode (PE1), die elektrisch mit dem ersten Ende (EP1) des lichtemittierenden Elements (LD) verbunden ist; und
eine zweite Elektrode (PE2), die von der ersten Elektrode (PE1) beabstandet und elektrisch mit dem zweiten Ende (EP2) des lichtemittierenden Elements (LD) verbunden ist,
wobei das Blindmuster (DMP) das gleiche Material wie die zweite Isolierschicht (INS2) umfasst;
wobei die erste Elektrode (PE1) und die zweite Elektrode (PE2) in dem Raum (SP) gebildet sind und innerhalb des Raums (SP) voneinander beabstandet sind, wobei das Blindmuster (DMP) dazwischen eingefügt ist.

2. Anzeigevorrichtung nach Anspruch 1, wobei das Blindmuster und die zweite Isolierschicht die gleiche Breite aufweisen.

3. Anzeigevorrichtung nach Anspruch 1 oder 2, wobei das Blindmuster eine erste Blindschicht (DML1), eine zweite Blindschicht (DML2) und eine dritte Blindschicht (DML3) umfasst, die aufeinanderfolgend in dem Raum (SP) gestapelt sind.

4. Anzeigevorrichtung nach Anspruch 3,
wobei sich die erste Blindschicht (DML1) auf der ersten Isolierschicht (INS1) befindet und die erste Isolierschicht berührt,
wobei sich die dritte Blindschicht (DML3) auf der hinteren Fläche des lichtemittierenden Elements (LD) befindet und die hintere Fläche des lichtemittierenden Elements berührt und
wobei sich die zweite Blindschicht (DML2) zwischen der ersten Blindschicht und der dritten Blindschicht befindet.

5. Anzeigevorrichtung nach Anspruch 4, wobei jede von der ersten Blindschicht (DML1) und der dritten Blindschicht (DML3) das gleiche Material wie die zweite Isolierschicht (INS2) umfasst und die zweite Blindschicht (DML) ein anderes Material als die zweite Isolierschicht (INS2) umfasst, wobei optional jede von der ersten Blindschicht, der dritten Blindschicht und der zweiten Isolierschicht eine anorganische Isolierschicht umfasst und die zweite Blindschicht ein organisches Isoliermaterial umfasst.

6. Anzeigevorrichtung nach einem der Ansprüche 1 bis 5, wobei sich das Blindmuster so befindet, dass es der zweiten Isolierschicht in dem Raum entspricht.

7. Anzeigevorrichtung nach Anspruch 1, wobei das Blindmuster in einer Querschnittsansicht eine polygonale Form aufweist, die Seitenflächen beinhaltet, die unterschiedliche Neigungen aufweisen.

8. Anzeigevorrichtung nach einem der Ansprüche 1 bis 4,
wobei jedes der Vielzahl von Pixeln eine dritte Isolierschicht (INS3) auf der zweiten Isolierschicht umfasst,
wobei die dritte Isolierschicht (INS3) eine von der ersten und der zweiten Elektrode (PE1, PE2) bedeckt und
wobei sich die andere von der ersten und der zweiten Elektrode auf der dritten Isolierschicht befindet.

9. Anzeigevorrichtung nach Anspruch 8, wobei sich das Blindmuster benachbart zu einer von der ersten und der zweiten Ausrichtungselektrode in dem Raum befindet.

10. Anzeigevorrichtung nach einem der Ansprüche 2 bis 9, wobei die erste Elektrode (PE1) und die zweite Elektrode (PE2) voneinander beabstandet sind, wobei die zweite Isolierschicht (INS2) dazwischen eingefügt ist.

11. Anzeigevorrichtung nach einem der vorhergehenden Ansprüche, wobei jedes der Vielzahl von Pixeln Folgendes umfasst:
einen Emissionsbereich und einen Nicht-Emissionsbereich;
eine erste Bank, die sich in dem Nicht-Emissionsbereich befindet und eine Öffnung beinhaltet, die dem Emissionsbereich entspricht;
das lichtemittierende Element, das sich in dem Emissionsbereich befindet;
eine Farbumwandlungsschicht über der ersten und der zweiten Elektrode, und die sich in dem Emissionsbereich befindet, um dem lichtemittierenden Element zu entsprechen, wobei die Farbumwandlungsschicht Farbumwandlungspartikel umfasst;
eine zweite Bank auf der ersten Bank in dem Nicht-Emissionsbereich, und die dazu konfiguriert ist, die Farbumwandlungsschicht einzuschließen; und
eine Farbfilterschicht, die sich auf der Farbumwandlungsschicht befindet und die dazu konfiguriert ist, zu ermöglichen, dass Licht, das von der Farbumwandlungsschicht emittiert wird, selektiv durch diese hindurchtritt.

12. Verfahren zur Herstellung einer Anzeigevorrichtung, umfassend:
Bilden einer ersten Ausrichtungselektrode (ALE1) und einer zweiten Ausrichtungselektrode (ALE2), die voneinander beabstandet sind, auf einem Substrat (SUB);
Bilden einer ersten Isolierschicht (INS1) auf der ersten Ausrichtungselektrode (ALE1) und der zweiten Ausrichtungselektrode (ALE2);
Ausrichten eines lichtemittierenden Elements (LD) auf der ersten Isolierschicht (INS1) zwischen der ersten Ausrichtungselektrode (ALE1) und der zweiten Ausrichtungselektrode (ALE2);
Bilden einer ersten Schicht (FL) auf dem lichtemittierenden Element (LD) und der ersten Isolierschicht (INS1), wobei sich die erste Schicht (FL) auf jedem von einer hinteren Fläche des lichtemittierenden Elements (LD) und einer oberen Fläche der ersten Isolierschicht (INS1) in einem Raum (SP) befindet, der durch die das lichtemittierende Element (LD) und die erste Isolierschicht (INS1) eingeschlossen ist;
Bilden einer zweiten Schicht (SL) auf der ersten Schicht (FL), wobei die zweite Schicht (SL) zwischen der ersten Schicht (FL), die sich auf der hinteren Fläche des lichtemittierenden Elements (LD) befindet, und der ersten Schicht (FL), die sich auf der oberen Fläche der ersten Isolierschicht (INS1) in dem Raum (SP) befindet, ist;
Entfernen der zweiten Schicht (SL), die sich auf der ersten Schicht (FL) auf dem lichtemittierenden Element (LD) befindet, durch einen Trockenätzprozess;
Bilden einer zweiten Isolierschicht (INS2) auf einer oberen Fläche des lichtemittierenden Elements (LD) durch Entfernen eines Abschnitts der ersten Schicht (FL) durch einen Photolithographieprozess, wobei das Bilden der zweiten Isolierschicht (INS2) Bilden eines Blindmusters (DMP) durch Entfernen jeweiliger Abschnitte der ersten und der zweiten Schicht (FL, SL), die sich in dem Raum (SP) befinden, umfasst; und
Aufbringen eines leitfähigen Basismaterials, um eine erste Elektrode (PE1) und eine zweite Elektrode (PE2) zu bilden,
wobei das leitfähige Basismaterial durch die gegenüberliegenden Seiten des Raums (SP) mit dem dazwischen eingefügten Blindmuster (DMP) in den Raum (SP) gezogen wird.

## Revendications

1. Dispositif d'affichage comprenant une pluralité de pixels sur un substrat (SUB), dans lequel chacun de la pluralité de pixels comprend :
une première électrode d'alignement (ALE1) et une seconde électrode d'alignement (ALE2) situées sur le substrat (SUB) et espacées l'une de l'autre ;
une première couche isolante (INS1) sur la première électrode d'alignement (ALE1) et la seconde électrode d'alignement (ALE2) ;
un élément électroluminescent (LD) situé sur la première couche isolante (INS1) entre la première électrode d'alignement (ALE1) et la seconde électrode d'alignement (ALE2) ;
un motif factice (DMP) situé sur chacune d'une surface arrière de l'élément électroluminescent (LD) et d'une surface supérieure de la première couche isolante (INS1) dans un espace (SP) entouré par la première couche isolante (INS1) et l'élément électroluminescent (LD) ;
une deuxième couche isolante (INS2) située sur l'élément électroluminescent (LD) et exposant une première extrémité (EP1) et une seconde extrémité (EP2) de l'élément électroluminescent (LD) ;
une première électrode (PE1) électriquement connectée à la première extrémité (EP1) de l'élément électroluminescent (LD) ; et
une seconde électrode (PE2) espacée de la première électrode (PE1), et électriquement connectée à la seconde extrémité (EP2) de l'élément électroluminescent (LD),
dans lequel le motif factice (DMP) comprend le même matériau que la deuxième couche isolante (INS2) ;
dans lequel la première électrode (PE1) et la seconde électrode (PE2) sont formées dans l'espace (SP) et sont espacées l'une de l'autre au sein de l'espace (SP) avec le motif factice (DMP) interposé entre elles.

2. Dispositif d'affichage selon la revendication 1, dans lequel le motif factice et la deuxième couche isolante présentent la même largeur.

3. Dispositif d'affichage selon la revendication 1 ou 2, dans lequel le motif factice comprend une première couche factice (DML1), une deuxième couche factice (DML2) et une troisième couche factice (DML3) qui sont successivement empilées dans l'espace (SP).

4. Dispositif d'affichage selon la revendication 3,
dans lequel la première couche factice (DML1) est située sur la première couche isolante (INS1) et entre en contact avec la première couche isolante,
dans lequel la troisième couche factice (DML3) est située sur la surface arrière de l'élément électroluminescent (LD) et est en contact avec la surface arrière de l'élément électroluminescent, et
dans lequel la deuxième couche factice (DML2) est située entre la première couche factice et la troisième couche factice.

5. Dispositif d'affichage selon la revendication 4, dans lequel chacune de la première couche factice (DML1) et de la troisième couche factice (DML3) comprend le même matériau que la deuxième couche isolante (INS2), et la deuxième couche factice (DML) comprend un matériau différent de la deuxième couche isolante (INS2), éventuellement dans lequel chacune de la première couche factice, de la troisième couche factice et de la deuxième couche isolante comprend une couche isolante inorganique, et la deuxième couche factice comprend un matériau isolant organique.

6. Dispositif d'affichage selon l'une quelconque des revendications 1 à 5, dans lequel le motif factice est situé pour correspondre à la deuxième couche isolante dans l'espace.

7. Dispositif d'affichage selon la revendication 1, dans lequel, dans une vue de section transversale, le motif factice présente une forme polygonale comprenant des surfaces latérales présentant des inclinaisons différentes.

8. Dispositif d'affichage selon l'une quelconque des revendications 1 à 4,
dans lequel chacun de la pluralité de pixels comprend une troisième couche isolante (INS3) sur la deuxième couche isolante,
dans lequel la troisième couche isolante (INS3) recouvre l'une des première et seconde électrodes (PE1, PE2), et
dans lequel l'autre des première et seconde électrodes est située sur la troisième couche isolante.

9. Dispositif d'affichage selon la revendication 8, dans lequel le motif factice est situé de manière adjacente à l'une des première et seconde électrodes d'alignement dans l'espace.

10. Dispositif d'affichage selon l'une quelconque des revendications 2 à 9, dans lequel la première électrode (PE1) et la seconde électrode (PE2) sont espacées l'une de l'autre avec la deuxième couche isolante (INS2) interposée entre elles.

11. Dispositif d'affichage selon l'une quelconque des revendications précédentes, dans lequel chacun de la pluralité de pixels comprend :
une zone d'émission et une zone de non-émission ;
un premier banc situé dans la zone de non-émission, et comprenant une ouverture correspondant à la zone d'émission ;
l'élément électroluminescent situé dans la zone d'émission ;
une couche de conversion de couleur sur la première et la seconde électrodes et située dans la zone d'émission pour correspondre à l'élément électroluminescent, la couche de conversion de couleur comprenant des particules de conversion de couleur ;
un second banc sur le premier banc dans la zone de non-émission, et configuré pour enfermer la couche de conversion de couleur ; et
une couche de filtre coloré située sur la couche de conversion de couleurs et configurée pour permettre à de la lumière émise par la couche de conversion de couleurs de traverser sélectivement celle-ci.

12. Procédé de fabrication d'un dispositif d'affichage, comprenant :
la formation, sur un substrat (SUB), d'une première électrode d'alignement (ALE1) et d'une seconde électrode d'alignement (ALE2) espacées l'une de l'autre ;
la formation d'une première couche isolante (INS1) sur la première électrode d'alignement (ALE1) et la seconde électrode d'alignement (ALE2) ;
l'alignement d'un élément électroluminescent (LD) sur la première couche isolante (INS1) entre la première électrode d'alignement (ALE1) et la seconde électrode d'alignement (ALE2) ;
la formation d'une première couche (FL) sur l'élément électroluminescent (LD) et la première couche isolante (INS1), la première couche (FL) étant située sur chacune d'une surface arrière de l'élément électroluminescent (LD) et d'une surface supérieure de la première couche isolante (INS1) dans un espace (SP) entouré par l'élément électroluminescent (LD) et la première couche isolante (INS1) ;
la formation d'une seconde couche (SL) sur la première couche (FL), la seconde couche (SL) étant entre le première couche (FL) située sur la surface arrière de l'élément électroluminescent (LD) et la première couche (FL) située sur la surface supérieure de la première couche isolante (INS1) dans l'espace (SP) ;
le retrait, par un processus de gravure sèche, de la seconde couche (SL) qui est située sur la première couche (FL) sur l'élément électroluminescent (LD) ;
la formation d'une deuxième couche isolante (INS2) sur une surface supérieure de l'élément électroluminescent (LD) en retirant une partie de la première couche (FL) par un processus de photolithographie, dans lequel la formation de la deuxième couche isolante (INS2) comprend la formation d'un motif factice (DMP) en retirant des parties respectives de la première et de la seconde couches (FL, SL) situées dans l'espace (SP) ; et
l'application d'un matériau conducteur de base pour former une première électrode (PE1) et une seconde électrode (PE2),
dans lequel le matériau conducteur de base est tiré dans l'espace (SP) à travers les côtés opposés de l'espace (SP) avec le motif factice (DMP) interposé entre eux.
